# EUROPEAN PATENT APPLICATION

(11) **EP 4 686 358 A1**
(43) Date of publication of application: **28.01.2026**
(21) Application number: 25191028.7
(22) Date of filing: 22.07.2025
(51) Int. Cl.: H10K 59/121, H10K 59/131

(54) **DISPLAY DEVICE AND ELECTRONIC DEVICE INCLUDING THE SAME**

(30) Priority: 23.07.2024 KR 20240096874
(71) Applicant: Samsung Display Co., Ltd., Yongin-si, Gyeonggi-do 17113 (KR)
(72) Inventor: KIM, TAEGON, 17113 Yongin-si (KR); YOON, MIJIN, 17113 Yongin-si (KR); LEE, OUKJAE, 17113 Yongin-si (KR)
(74) Representative: Taor, Simon Edward William

(57) **Abstract**

A display device includes: a base layer including a display region and a non-display region in the base layer; a circuit layer on the base layer; and an element layer on the circuit layer, and including a light emitting element, wherein the circuit layer includes: a pixel circuit connected to the light emitting element; a data line connected to the pixel circuit; a vertical connecting line spaced apart from the data line in a first direction, and extending in a second direction; and a horizontal connecting line connecting the vertical connecting line to the data line in the display region, and extending in the first direction, wherein the pixel circuit includes a transistor including an oxide semiconductor pattern, wherein the horizontal connecting line includes an overlap part overlapping with a connecting pattern extending from the oxide semiconductor pattern, and wherein the transistor includes a gate overlapping with the overlap part.

## Description

### BACKGROUND

Aspects of some embodiments of the present disclosure described herein relate to a display device and an electronic device including the same.

In general, an electronic device, which provides images to users, such as a smartphone, a digital camera, a laptop computer, a navigation system, or a smart television includes a display device for displaying images. The display device generates images and provides the generated images to users through a display screen.

The display device includes a plurality of pixels to generate images and a plurality of lines connected to the pixels. The pixels receive driving signals through lines and are driven.

The above information disclosed in this Background section is only for enhancement of understanding of the background and therefore the information discussed in this Background section does not necessarily constitute prior art.

### SUMMARY

Aspects of some embodiments of the present disclosure described herein relate to a display device and an electronic device including the same, and for example, to a display device that is relatively improved in display quality and an electronic device including the same.

Aspects of some embodiments of the present disclosure include a display device that is relatively improved in display quality and an electronic device including the same.

According to some embodiments of the present disclosure, a display device includes a base layer including a display region and a non-display region defined in the base layer, a circuit layer on the base layer, and an element layer on the circuit layer, and including a light emitting element.

According to some embodiments, the circuit layer includes a pixel circuit connected to the light emitting element, a data line connected to the pixel circuit, a vertical connecting line spaced apart from the data line in a first direction, and extending in a second direction, and a horizontal connecting line to connect the vertical connecting line to the data line in the display region, and extending in the first direction.

According to some embodiments, the pixel circuit includes a transistor including an oxide semiconductor pattern, and the horizontal connecting line includes an overlap part overlapped with a connecting pattern extending from the oxide semiconductor pattern. According to some embodiments, the transistor includes a gate overlapping with the overlap part.

According to some embodiments of the present disclosure, a display device includes a base layer including a display region and a non-display region defined in the base layer, a circuit layer on the base layer, and an element layer on the circuit layer, and including a light emitting element.

According to some embodiments, the circuit layer includes pixel circuits connected to the light emitting element, a data line connected to the pixel circuits, a vertical connecting line spaced apart from the data line in a first direction, and extending in a second direction, and a horizontal connecting line to connect the vertical connecting line to the data line in the display region.

According to some embodiments, each of the pixel circuits includes a transistor including an oxide semiconductor pattern, and the horizontal connecting line overlaps with a connecting pattern to connect the oxide semiconductor patterns of the pixel circuits, and is in a non-overlapping state with the oxide semiconductor patterns.

According to some embodiments, an electronic device includes a display panel including a pixel, a panel driver driving the display panel, a driving controller controlling a driving of the panel driver, and a main processor providing an image signal to the driving controller.

According to some embodiments, the display panel includes a base layer including a display region and a non-display region defined in the base layer, a circuit layer on the base layer, and an element layer on the circuit layer, and including a light emitting element.

According to some embodiments, the circuit layer includes a pixel circuit connected to the light emitting element, a data line connected to the pixel circuit, a vertical connecting line spaced apart from the data line in a first direction, and extending in a second direction, and a horizontal connecting line to connect the vertical connecting line to the data line in the display region, and extending in the first direction.

According to some embodiments, the pixel circuit includes a transistor including an oxide semiconductor pattern, and the horizontal connecting line includes an overlap part overlapped with a connecting pattern extending from the oxide semiconductor pattern. According to some embodiments, the transistor includes a gate overlapping with the overlap part.

According to an aspect, there is provided a display device as set out in claim 1. Additional features are set out in claims 2 to 10. According to an aspect, there is provided a display device as set out in claim 11. Additional features are set out in claims 12 to 14. According to an aspect, there is provided an electronic device as set out in claim 15.

### BRIEF DESCRIPTION OF THE DRAWINGS

The above and other aspects and features of some embodiments of the present disclosure will become more apparent by describing in more detail aspects of some embodiments thereof with reference to the accompanying drawings.
FIG. 1 is a perspective view of a display device according to some embodiments of the present disclosure.
FIG. 2A is an exploded perspective view of a display device according to some embodiments of the present disclosure.
FIG. 2B is a cross-sectional view of a display device according to some embodiments of the present disclosure.
FIG. 3 is a block diagram of a display device according to some embodiments of the present disclosure.
FIG. 4A is a circuit diagram illustrating a pixel and a sensor according to some embodiments of the present disclosure.
FIG. 4B is a waveform diagram to describe operations of a pixel and a sensor illustrated in FIG. 4A.
FIG. 5 is a plan view of a display panel according to some embodiments of the present disclosure.
FIG. 6 is a cross-sectional view of a display panel according to some embodiments of the present disclosure.
FIGS. 7A to 7F are plan views illustrating the layout of each layer included in a circuit layer according to some embodiments of the present disclosure.
FIG. 8A is an enlarged plan view illustrating an enlarged portion of a display panel according to some embodiments of the present disclosure.
FIG. 8B is a cross-sectional view taken along the line I-I' of FIG. 8A.
FIG. 8C is a circuit diagram illustrating the relationship between the fourth transistor and the parasitic transistor illustrated in FIG. 8A.
FIG. 9A is an enlarged plan view illustrating an enlarged portion of a display panel according to some embodiments of the present disclosure.
FIG. 9B is a cross-sectional view taken along the line II-II' of FIG. 9A.
FIGS. 10A to 10E are plan views illustrating the layout of each layer included in a circuit layer according to some embodiments of the present disclosure.
FIG. 11 is an enlarged plan view illustrating an enlarged portion of a display panel according to some embodiments of the present disclosure.
FIG. 12 is a cross-sectional view taken along the line III-III' of FIG. 11.
FIG. 13 is an enlarged plan view illustrating an enlarged portion of a display panel according to some embodiments of the present disclosure.
FIG. 14 is an enlarged plan view illustrating an enlarged portion of a display panel according to some embodiments of the present disclosure.
FIG. 15 is a block diagram of an electronic device, according to some embodiments of the present disclosure.

### DETAILED DESCRIPTION

In the specification, the expression that a first component (or region, layer, or part) is "on", "connected to", or "coupled to" a second component refers to that the first component is directly on, connected to, or coupled to the second component or refers to that a third component is interposed therebetween.

The same reference numeral will be assigned to the same component. In addition, in drawings, thicknesses, proportions, and dimensions of components may be exaggerated to describe the technical features effectively. The term "and/or" includes any and all combinations of one or more of associated components
Although the terms "first", or "second" may be used to describe various components, the components should not be construed as being limited by the terms. The terms are only used to distinguish one component from another component. For example, without departing from the scope of the present disclosure, a first component may be referred to as a second component, and similarly, the second component may be referred to as the first component. The singular forms are intended to include the plural forms unless the context clearly indicates otherwise.

In addition, the terms "under", "at a lower portion", "above", "an upper portion" are used to describe the relationship between components illustrated in drawings. The terms are relative and will be described with reference to a direction indicated in the drawing.

It will be further understood that the terms "comprise," "include," or "including," or "have" or "having" specify the presence of stated features, numbers, steps, operations, components, parts, or the combination thereof, but do not preclude the presence or addition of one or more other features, numbers, steps, operations, components, components, and/or the combination thereof.

Unless defined otherwise, all terms (including technical terms and scientific terms) used in the specification have the same meaning as commonly understood by one skilled in the art to which the present disclosure belongs. Furthermore, terms such as terms defined in the dictionaries commonly used should be interpreted as having a meaning consistent with the meaning in the context of the related technology, and should not be interpreted in ideal or overly formal meanings unless explicitly defined herein.

Hereinafter, aspects of some embodiments of the present disclosure will be described in more detail with reference to drawings.

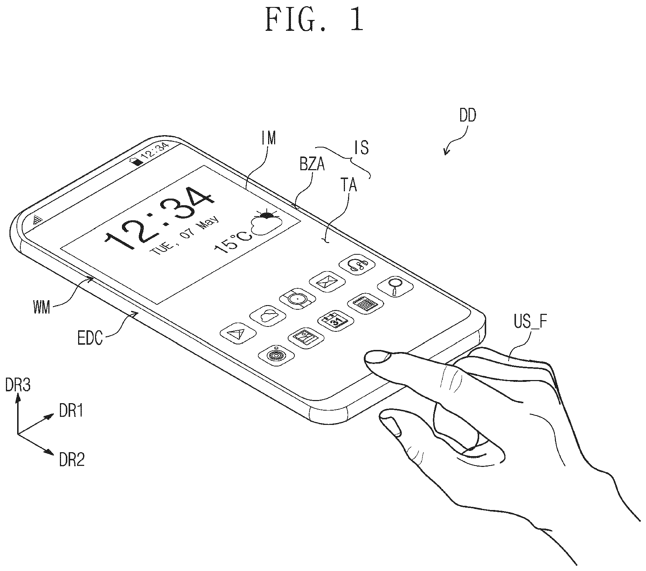

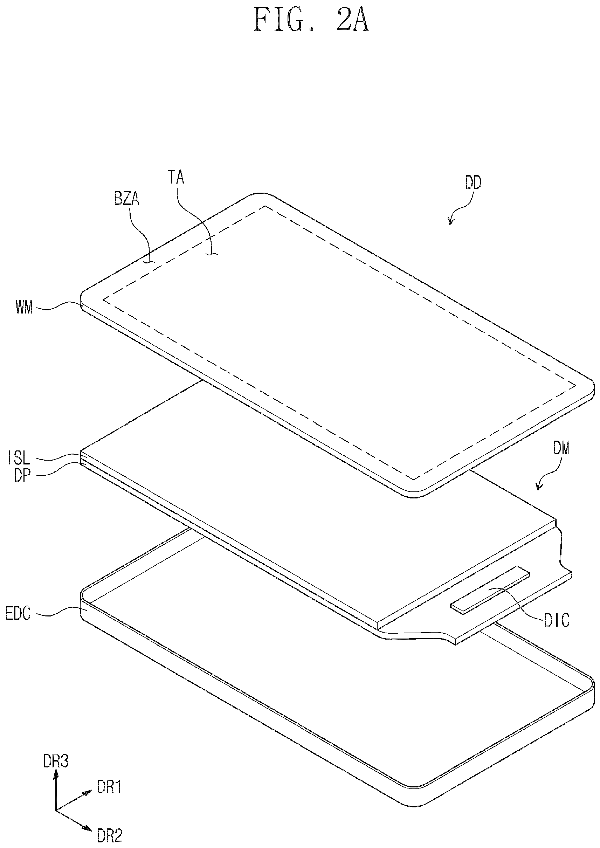

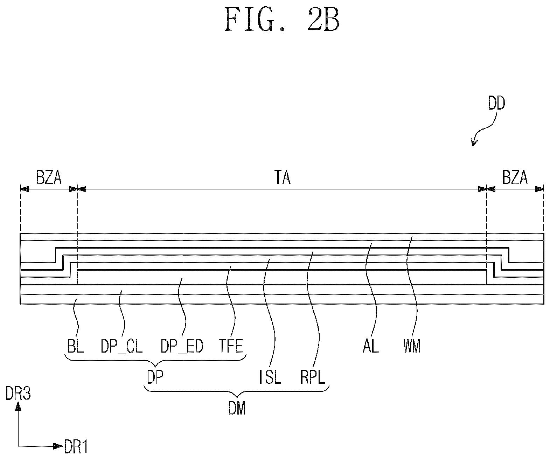

FIG. 1 is a perspective view illustrating a display device according to some embodiments of the present disclosure, FIG. 2A is an exploded perspective view of a display device according to some embodiments of the present disclosure, and FIG. 2B is a cross-sectional view of a display device according to some embodiments of the present disclosure.

Referring to FIGS. 1, 2A and 2B, a display device DD according to some embodiments of the present disclosure may have the shape of a rectangle having a shorter side parallel to a first direction DR1 and a longer side parallel to a second direction DR2 crossing the first direction DR1. However, embodiments according to the present disclosure are not limited thereto. For example, the display device DD may be implemented in various shapes such as a circle, an ellipse, a polygon, or an irregular shape.

The display device DD may be a device that is activated in response to an electrical signal. The display device DD may include various embodiments. For example, the display device DD may be applied to an electronic device such as a smart watch, a tablet PC, a laptop computer, or a smart television.

Hereinafter, a direction normal (or perpendicular or substantially normal) to a plane defined by the first direction DR1 and the second direction DR2 is defined as a third direction DR3. In the specification, the meaning of "when viewed in a plan view" may refer to "when viewed in the third direction DR3".

A top surface of the display device DD may be defined as a display surface IS, and may be parallel to a plane defined by the first direction DR1 and the second direction DR2. Images IM generated by the display device DD may be provided to the user through the display surface IS.

The display surface IS may be divided into a transmission region TA and a bezel region BZA. The transmission region TA may be a region for displaying the images IM. A user views the images IM through the transmission region TA. According to some embodiments, the transmission region TA have vertexes in a rounded-rectangular shape. However, this is illustrated as an example. The transmission region TA may be implemented in various shapes and may not be limited to any one embodiment.

The bezel region BZA is adjacent to (e.g., in a periphery or outside a footprint of) the transmission region TA. The bezel region BZA may have specific color. The bezel region BZA may surround the transmission region TA. Accordingly, the shape of the transmission region TA may be defined by the bezel region BZA. However, this is illustrated as an example. For example, the bezel region BZA may be only located adjacent only to one side of the transmission region TA or may be omitted.

The display device DD may sense an external input applied from the outside. The external input may include various types of inputs which are provided from the outside of the display device DD. For example, as well as a contact by a part of the human body such as the user's hand US_F or a contact by a separate device (for example, an active pen or a digitizer), the external input may include an external input (for example, hovering) that is applied in a state that the user's hand US_F approaches the display device DD or is adjacent to the display device DD within a specific distance. In addition, the external input may have various types such as force, pressure, a temperature, and a light.

The display device DD may include a window WM, a display module DM, and a housing EDC. According to some embodiments, the window WM and the housing EDC are coupled to each other to form the outer appearance of the display device DD.

A front surface of the window WM defines the display surface IS of the display device DD. The window WM may include an optically transparent insulating material. For example, the window WM may include glass or plastic. The window WM may be implemented in a multi-layer structure or a single-layer structure. For example, the window WM may include a plurality of plastic films bonded to each other by an adhesive agent or may include a glass substrate and a plastic film bonded to each other by an adhesive agent.

The display module DM may include a display panel DP and an input sensing layer ISL. The display panel DP may display an image in response to an electrical signal, and the input sensing layer ISL may sense an external input applied from the outside. The external input may be provided in various forms.

The display panel DP according to some embodiments of the present disclosure may be an emissive-type display panel, and embodiments according to the present disclosure are not particularly limited thereto. For example, the display panel DP may be an organic light emitting display panel, an inorganic light emitting display panel, or a quantum dot light emitting display panel. A light emitting layer of the organic light emitting display panel may include an organic light emitting material, and a light emitting layer of the inorganic light emitting display panel may include an inorganic light emitting material. A light emitting layer of the quantum dot light emitting display panel may include a quantum dot, or a quantum rod. In the following description, the display panel DP is an organic light emitting display panel.

Referring to FIG. 2B, the display panel DP includes a base layer BL, a circuit layer DP_CL, an element layer DP_ED, and an encapsulating layer TFE. The display panel DP according to the present disclosure may be a flexible display panel. However, embodiments according to the present disclosure are not limited thereto. For example, the display panel DP may be a foldable display panel, which is folded about or along a folding axis, or a rigid display panel.

The base layer BL may include a synthetic resin layer. The synthetic resin layer may be a polyimide-based resin layer, and the material thereof is not particularly limited. Besides, the base layer BL may include a glass substrate, a metal substrate, or an organic/inorganic composite material substrate.

The circuit layer DP_CL is located on the base layer BL. The circuit layer DP_CL is interposed between the base layer BL and the element layer DP_ED. The circuit layer DP_CL includes at least one insulating layer and a circuit element. Hereinafter, the insulating layer included in the circuit layer DP_CL may be referred to as an intermediate insulating layer. The intermediate insulating layer includes at least one intermediate inorganic film and at least one intermediate organic film. The circuit element may include a pixel driving circuit included in each of a plurality of pixels to display an image and a sensor driving circuit included in each of a plurality of sensors to recognize external information. The external information may be biometrics information. According to some embodiments of the present disclosure, the sensor may include a fingerprint recognizing sensor, a proximity sensor, an iris recognizing sensor, a blood measuring sensor, or an illuminance sensor. In addition, the sensor may be an optical sensor to optically recognize biometrics information. The circuit layer DP_CL may further include signal lines connected to the pixel driving circuit and/or the sensor driving circuit.

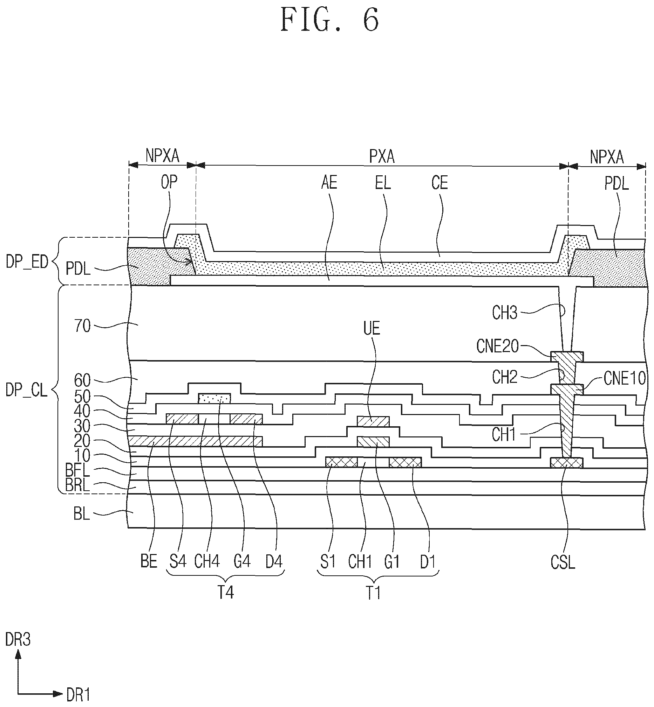

The element layer DP_ED may include a light emitting element included in each pixel and a light receiving element included in each of the sensors. According to some embodiments of the present disclosure, the light receiving element may be a photodiode. The light receiving element may be a sensor to sense light reflected from the fingerprint of the user or a sensor reacting to light. The circuit layer DP_CL and the element layer DP_ED will be described in detail later with reference to FIG. 6.

The encapsulating layer TFE encapsulates the element layer DP_ED. The encapsulating layer TFE may include at least one organic film and at least one inorganic film. The inorganic film may include an inorganic material, and may protect the element layer DP_ED from moisture/oxygen. The inorganic film may include a silicon nitride layer, a silicon oxy nitride layer, a silicon oxide layer, a titanium oxide layer, or an aluminum oxide layer, but embodiments of the present disclosure are not particularly limited thereto. The organic film may include an organic material, and may protect the element layer DP_ED from foreign substances such as dust particles.

The input sensing layer ISL may be formed on the display panel DP. The input sensing layer ISL may be directly located on the encapsulating layer TFE. According to some embodiments of the present disclosure, the input sensing layer ISL may be formed on the display panel DP through subsequent processes. In other words, when the input sensing layer ISL is directly located on the display panel DP, an adhesive film is not located between the input sensing layer ISL and the encapsulating layer TFE. Alternatively, an adhesive film may be located between the input sensing layer ISL and the display panel DP. In this case, the input sensing layer ISL and the display panel DP are not fabricated through the subsequent processes. In other words, after fabricating the input sensing layer ISL through a process separate from that of the display panel DP, the input sensing layer ISL may be fixed on a top surface of the display panel DP through the adhesive film.

The input sensing layer ISL may sense an external input (for example, a touch of the user), may change the sensed input into a specific input signal, and may apply the input signal to the display panel DP. The input sensing layer ISL may include a plurality of sensing electrodes to sense an external input. The sensing electrodes may sense the external input through a capacitive manner. The display panel DP may receive an input signal applied from the input sensing layer ISL and may generate an image corresponding to the input signal.

The display module DM may further include an anti-reflective layer RPL. The anti-reflective layer RPL may reduce the reflectance of external light incident from the top surface of the display device DD toward the display panel DP. The external light may not be viewed to the user due to the anti-reflective layer RPL. According to some embodiments of the present disclosure, the anti-reflective layer RPL may be located on the input sensing layer ISL. However, embodiments according to the present disclosure are not limited thereto. The anti-reflective layer RPL may be interposed between the display panel DP and the input sensing layer ISL. The anti-reflective layer RPL may include a plurality of color filters arranged to correspond to the pixels, respectively. The color filters may filter the external light having the same color as that of the pixels. In this case, the external light may not be viewed by the user. However, embodiments according to the present disclosure are not limited thereto. For example, the anti-reflective layer RPL may include a phase retarder and/or a polarizer, to reduce the reflectance of the external light.

The display device DD according to some embodiments of the present disclosure may further include an adhesive layer AL. The window WM may be attached to the anti-reflective layer RPL through the adhesive layer AL. The adhesive layer AL may include an optical clear adhesive, an optically clear adhesive resin, or a pressure sensitive adhesive (PSA).

The display module DM may further include a driving chip DIC. According to some embodiments of the present disclosure, the driving chip DIC may be mounted on the display panel DP while being adjacent to an end portion of the display panel DP. However, alternatively, the driving chip DIC may be mounted on a flexible circuit film coupled to one side of the display panel DP.

The housing EDC is coupled to the window WM. The housing EDC is coupled to the window WM to provide a specific inner space. The display module DM may be received in the inner space. The housing EDC may include a material having higher rigidity. For example, the housing EDC may include glass, plastic, or metal or may include a plurality of frames and/or a plurality of plates including a combination thereof. The housing EDC may stably protect the components of the display device DD, which are received in the inner space, from an external impact. According to some embodiments, a battery module may be interposed between the display module DM and the housing EDC to supply a power necessary for the overall operation of the display device DD.

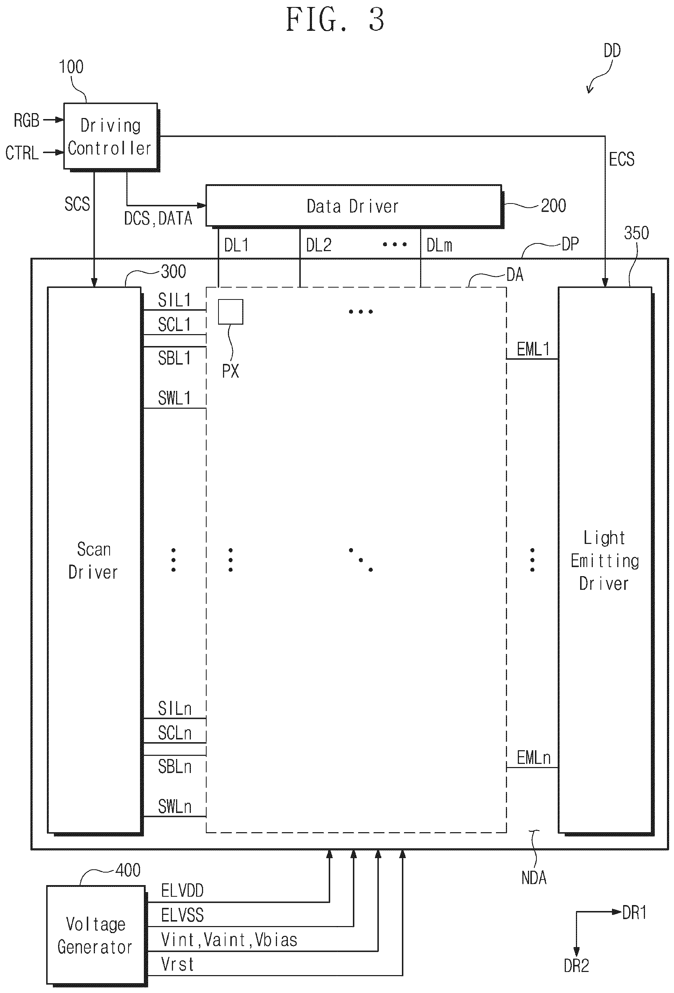

FIG. 3 is a block diagram of a display device according to some embodiments of the present disclosure.

Referring to FIG. 3, the display device DD includes the display panel DP, a panel driver, and a driving controller 100. According to some embodiments of the present disclosure, the panel driver includes a data driver 200, a scan driver 300, a light emitting driver 350, and a voltage generator 400.

The driving controller 100 receives an image signal RGB and a control signal CTRL. The driving controller 100 generates image data DATA by transforming a data format of the image signal RGB to be matched to the specification for an interface with the data driver 200. The driving controller 100 outputs a first control signal SCS, a second control signal ECS, and a third control signal DCS.

The data driver 200 receives the third control signal DCS and the image data DATA from the driving controller 100. The data driver 200 converts the image data DATA into data signals, and outputs the data signals to a plurality of data lines DL1 to DLm to be described later. The data signals refer to analog voltages corresponding to grayscale values of the image data DATA. According to some embodiments of the present disclosure, the data driver 200 may be embedded in the driving chip DIC illustrated in FIG. 2A.

The scan driver 300 receives the first control signal SCS from the driving controller 100. The scan driver 300 may output scan signals to scan lines in response to the first control signal SCS.

The voltage generator 400 generates voltages necessary for an operation of the display panel DP. According to some embodiments, the voltage generator 400 generates a first driving voltage ELVDD, a second driving voltage ELVSS, a first initializing voltage Vint, a second initializing voltage Vaint, a bias voltage Vbias, and a reset voltage Vrst.

The display panel DP may include a display region DA corresponding to the transmission region TA (illustrated in FIG. 1) and a non-display region NDA corresponding to the bezel region BZA (illustrated in FIG. 1).

The display panel DP may include a plurality of pixels PX located in the display region DA. Although FIG. 3 illustrates a single pixel PX, as a person having ordinary skill in the art would appreciate, the display panel DP may include any suitable number of pixels PX (e.g., arranged in a matrix of rows and columns) according to the design and size of the display panel DP.

The display panel DP further includes initializing scan lines SIL1 to SILn, compensating scan lines SCL1 to SCLn, write scan lines SWL1 to SWLn, black scan lines SBL1 to SBLn, light emitting control lines EML1 to EMLn, and data lines DL1 to DLm. The initializing scan lines SIL1 to SILn, the compensating scan lines SCL1 to SCLn, the write scan lines SWL1 to SWLn, the black scan lines SBL1 to SBLn, and the light emitting control lines EML1 to EMLn extend in the first direction DR1. The initializing scan lines SIL1 to SILn, the compensating scan lines SCL1 to SCLn, the write scan lines SWL1 to SWLn, the black scan lines SBL1 to SBLn, and the light emitting control lines EML1 to EMLn are arranged to be spaced from each other in the second direction DR2. The data lines DL1 to DLm extend in the second direction DR2, and are arranged to be spaced from each other in the first direction DR1. In this case, "m" and "n" are natural numbers equal to or greater than '1'.

The plurality of pixels PX are electrically connected to the initializing scan lines SIL1 to SILn, the compensating scan lines SCL1 to SCLn, the write scan lines SWL1 to SWLn, the black scan lines SBL1 to SBLn, the light emitting control lines EML1 to EMLn, and the data lines DL1 to DLm. For example, each of the plurality of pixels PX may be electrically connected to four scan lines. However, the number of scan lines connected to each pixel PX is not limited thereto and may be changed.

The scan driver 300 may be located in the non-display region NDA of the display panel DP. The scan driver 300 receives the first control signal SCS from the driving controller 100. In response to the first control signal SCS, the scan driver 300 outputs initializing scan signals to the initializing scan lines SIL1 to SILn and may output compensating scan signals to the compensating scan lines SCL1 to SCLn. In addition, in response to the first control signal SCS, the scan driver 300 may output write scan signals to the write scan lines SWL1 to SWLn and may output black scan signals to the black scan lines SBL1 to SBLn. Alternatively, the scan driver 300 may include a first scan driver and a second scan driver. The first scan driver may output the initializing scan signals and the compensating scan signals, and the second scan driver may output the write scan signals and the black scan signals.

The light emitting driver 350 may be located in the non-display region NDA of the display panel DP. The light emitting driver 350 receives the second control signal ECS from the driving controller 100. The light emitting driver 350 may output light emitting control signals to the light emitting control lines EML1 to EMLn, in response to the second control signal ECS. Alternatively, the scan driver 300 may be connected to the light emitting control lines EML1 to EMLn. In this case, the light emitting driver 350 may be omitted, and the scan driver 300 may output light emitting control signals to the light emitting control lines EML1 to EMLn.

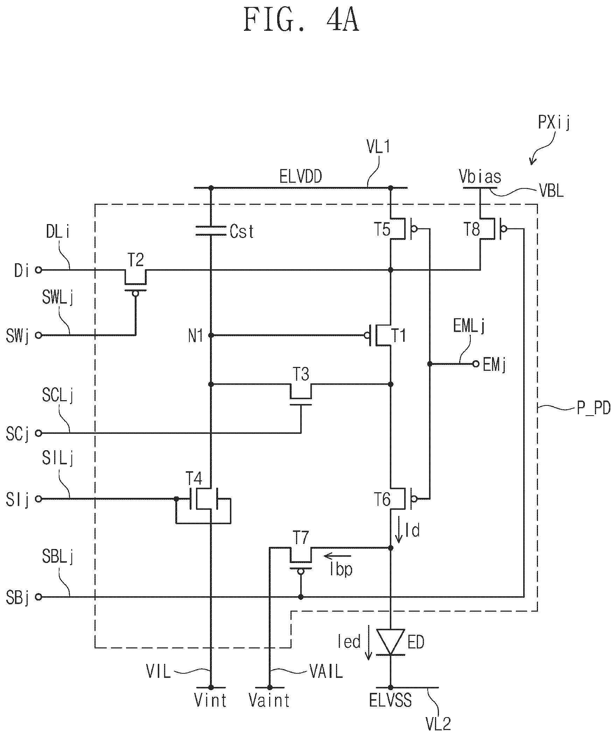

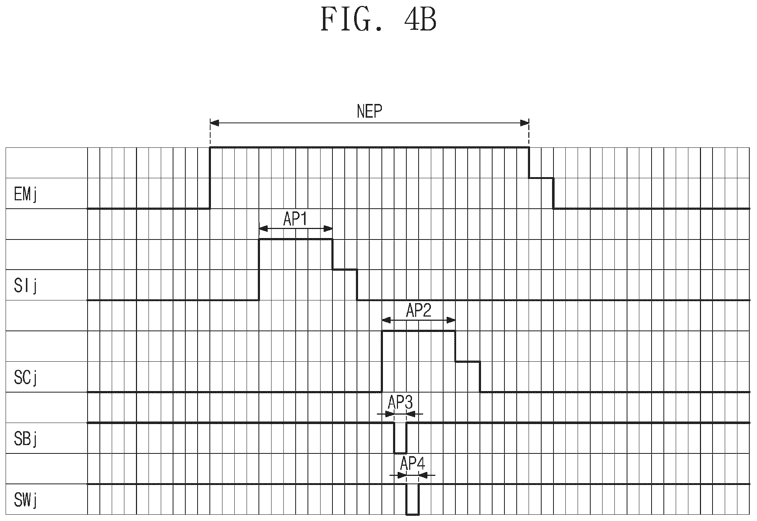

FIG. 4A is a circuit diagram illustrating a pixel and a sensor according to some embodiments of the present disclosure, and FIG. 4B is a waveform diagram to describe the operations of the pixel and the sensor illustrated in FIG. 4A.

FIG. 4A illustrates an equivalent circuit diagram of one pixel PXij of the plurality of pixels PX illustrated in FIG. 3. Because each of the plurality of pixels PX has the same circuit structure, the circuit structure of the pixel PXij will be representatively described and some details of the remaining pixels PX may be omitted in the following description. Additionally, although FIG. 4A illustrates various components in a pixel PXij according to some embodiments, embodiments according to the present disclosure are not limited thereto, and according to various embodiments, the pixel PXij may include additional components or fewer components without departing from the scope of embodiments according to the present disclosure.

Referring to FIG. 4A, the pixel PXij may be connected to an i-th data line DLi of the data lines DL1 to DLm, a j-th initializing scan line SILj of the initializing scan lines SIL1 to SILn, a j-th compensating scan line SCLj of the compensating scan lines SCL1 to SCLn, a j-th write scan line SWLj of the write scan lines SWL1 to SWLn, a j-th black scan line SBLj of the black scan lines SBL1 to SBLn, and a j-th light emitting control line EMLj of the light emitting control lines EML1 to EMLn.

The pixel PXij includes a light emitting element ED and a pixel driving circuit P_PD. The light emitting element ED may be a light emitting diode. According to an embodiment of the present disclosure, the light emitting element ED may be an organic light emitting diode including an organic light emitting layer.

The pixel driving circuit P_PD includes first to eighth transistors T1, T1, T2, T3, T4, T5, T6, T7, and T8, and one capacitor Cst. At least one of the first to eighth transistors T1 to T8 may be a transistor having a low-temperature polycrystalline silicon (LTPS) semiconductor layer. Some of the first to eighth transistors T1 to T8 may be P-type transistors, and the remaining transistors may be N-type transistors. At least one of the first to eighth transistors T1 to T8 may be a transistor having an oxide semiconductor layer. For example, the third and fourth transistors T3 and T4 may be oxide semiconductor transistors, and the first, second, and fifth to eighth transistors T1, T2, and T5 to T8 may be LTPS transistors. The third and fourth transistors T3 and T4 may be NMOS transistors.

A configuration of the pixel driving circuit P_PD according to the present disclosure is not limited to the embodiments illustrated in FIG. 4A. The pixel driving circuit P_PD illustrated in FIG. 4A is provided only for the illustrative purpose, and the configuration of the pixel driving circuit P_PD may be modified and implemented. For example, all of the first, second, and fifth to eighth transistors T1, T2, and T5 to T8 may be P-type transistors or N-type transistors.

The j-th initializing scan line SILj, the j-th compensating scan line SCLj, the j-th write scan line SWLj, the j-th black scan line SBLj, and the j-th light emitting control line EMLj may transmit a j-th initializing scan signal SIj, a j-th compensating scan signal SCj, a j-th write scan signal SWj, a j-th black scan signal SBj, and a j-th light emitting control signal EMj to the pixel PXij, respectively. The i-th data line DLi transmits the i-th data signal Di to the pixel PXij. The i-th data signal Di may have a voltage level corresponding to the image signal RGB (see FIG. 3) input to the display device DD (see FIG. 3).

According to some embodiments of the present disclosure, the pixel PXij may be connected to the first and second driving voltage lines VL1 and VL2, the first and second initializing voltage lines VIL and VAIL, and the bias voltage line VBL. The first driving voltage line VL1 may transmit the first driving voltage ELVDD to the pixel PXij, and the second driving voltage line VL2 may transmit the second driving voltage ELVSS to the pixel PXij. In addition, the first initializing voltage line VIL may transmit the first initializing voltage Vint to the pixel PXij, and the second initializing voltage line VAIL may transmit the second initializing voltage Vaint to the pixel PXij. The bias voltage line VBL may transmit the bias voltage Vbias to the pixel PXij.

The first transistor T1 is connected between the first driving voltage line VL1 for receiving the first driving voltage ELVDD and the light emitting element ED. The first transistor T1 includes a first electrode connected to the first driving voltage line VL1 through the fifth transistor T5, a second electrode connected to an anode electrode of the light emitting element ED through the sixth transistor T6, and a third electrode (for example, a gate electrode) connected to the first terminal (for example, a first node N1) of the capacitor Cst. The first transistor T1 may receive the data signal Di through the i-th data line DLi depending on a switching operation of the second transistor T2 and then may supply a driving current Id to the light emitting element ED.

The second transistor T2 is connected between the i-th data line DLi and the first electrode of the first transistor T1. The second transistor T2 includes a first electrode connected to the i-th data line DLi, a second electrode connected to the first electrode of the first transistor T1, and a third electrode (for example, a gate electrode) connected to the j-th write scan line SWLj. The second transistor T2 may be turned on in response to the write scan signal SWj transmitted through the j-th write scan line SWLj to transmit the i-th data signal Di transmitted from i-th the data line DLi to the first electrode of the first transistor T1.

The third transistor T3 is connected between the second electrode of the first transistor T1 and the first node N1. The third transistor T3 may include a first electrode connected to the third electrode of the first transistor T1, a second electrode connected to the second electrode of the first transistor T1, and a third electrode (for example, a gate electrode) connected to the j-th compensating scan line SCLj. The third transistor T3 may be turned on in response to the j-th compensating scan signal SCj, which is received through the j-th compensating scan line SCLj, to connect the third electrode and the second electrode of the first transistor T1, such that the first transistor T1 may be diode-connected.

The fourth transistor T4 is connected between the first initializing voltage line VIL applied with the first initializing voltage Vint and the first node N1. The fourth transistor T4 includes a first electrode connected to the first initializing voltage line VIL for transmitting the first initializing voltage Vint, a second electrode connected to the first node N1, and a third electrode (for example, a gate electrode) connected to the j-th initializing scan line SILj. The fourth transistor T4 is turned on in response to the j-th initializing scan signal SIj received through the j-th initializing scan line SILj. The fourth transistor T4 turned on transmits the first initializing voltage Vint to the first node N1 to initialize a potential (that is, a potential of the first node N1) of the third electrode of the first transistor T1.

The fifth transistor T5 includes a first electrode connected to the first driving voltage line VL1, a second electrode connected to the first electrode of the first transistor T1, and a third electrode (for example, a gate electrode) connected to the j-th light emitting control line EMLj.

The sixth transistor T6 may include a first electrode connected to the second electrode of the first transistor T1, a second electrode connected to the anode electrode of the light emitting element ED, and a third electrode (for example, a gate electrode) connected to the j-th light emitting control line EMLj.

The fifth and sixth transistors T5 and T6 are simultaneously (or concurrently) turned on in response to the j-th light emitting control signal EMj received through the j-th light emitting control line EMLj. The first driving voltage ELVDD applied through the turned-on fifth transistor T5 may be transmitted to the light emitting element ED after compensated through the diode-connected first transistor T1.

The seventh transistor T7 includes a first electrode connected to the second initializing voltage line VAIL for transmitting the second initializing voltage Vaint, a second electrode connected to the second electrode of the sixth transistor T6, and a third electrode (for example, a gate electrode) connected to the j-th black scan line SBLj. A voltage level of the second initializing voltage Vaint may be lower than or equal to that of the first initializing voltage Vint.

The eighth transistor T8 includes a first electrode connected to the bias voltage line VBL for transmitting the bias voltage Vbias, a second electrode connected to the first electrode of the first transistor T1, and a third electrode (for example, a gate electrode) connected to the j-th black scan line SBLj.

The seventh and eighth transistors T7 and T8 are simultaneously (or concurrently) turned on in response to the j-th black scan signal SBj received through the j-th black scan line SBLj. The second initializing voltage Vaint applied through the seventh transistor T7 turned on may be transmitted to the anode electrode of the light emitting element ED. Accordingly, the anode electrode of the light emitting element ED may be initialized to the second initializing voltage Vaint. The bias voltage Vbias applied through the eighth transistor T8, which is turned on, may be transmitted to the first electrode of the first transistor T1. Accordingly, the bias voltage Vbias may be periodically applied to the first electrode of the first transistor T1, thereby preventing or reducing instances of the display quality being degraded as the potential difference between the first and second electrodes of the first transistor T1 is increased to a specific level or more due to a hysteresis phenomenon.

A first terminal of the capacitor Cst is connected to the third electrode of the first transistor T1 as described above, and a second terminal of the capacitor Cst is connected to the first driving voltage line VL1. A cathode electrode of the light emitting element ED may be connected to the second driving voltage line VL2 for transmitting the second driving voltage ELVSS. The voltage level of the second driving voltage ELVSS may be lower than the voltage level of the first driving voltage ELVDD. According to some embodiments of the present disclosure, the voltage level of the second driving voltage ELVSS may be lower than the voltage levels of the first and second initializing voltages Vint and Vaint.

Referring to FIGS. 4A and 4B, the j-th light emitting control signal EMj has a high level during a non-emission period NEP. Within the non-emission period NEP, the j-th initializing scan signal SIj is activated. During an active period AP1 (hereinafter referred to as a "first active period") of the j-th initializing scan signal SIj, when the j-th initializing scan signal SIj having the high level is applied through the j-th initializing scan line SILj, the fourth transistor T4 is turned on in response to the j-th initializing scan signal SIj having the high level. The first initializing voltage Vint is transmitted to the third electrode of the first transistor T1 through the fourth transistor T4 turned on, and the first node N1 is initialized to the first initializing voltage Vint. Accordingly, the first active period AP1 may be defined as an initializing period of the pixel PXij.

Next, when the j-th compensating scan signal SCj is activated, and when the j-th compensating scan signal SCj having the high level is applied through the j-th compensating scan line SCLj, during an active period AP2 (hereinafter referred to as a "second active period") of the j-th compensating scan signal SCj, the third transistor T3 is turned on. The first transistor T1 is diode-connected by the third transistor T3 turned on, to be forward-biased. The first active period AP1 may be in a non-overlapping state with the second active period AP2.

The j-th write scan signal SWj is activated within the second active period AP2. During an active period AP4 (hereinafter, referred to as a "fourth active period), the j-th write scan signal SWj has a low level. During the fourth active period AP4, the second transistor T2 is turned on by the j-th write scan signal SWj having the low level. In this case, the third electrode of the first transistor T1 receives a compensating voltage "Di - Vth" which is obtained by reducing the i-th data signal Di, which is applied through the i-th data line DLi, by the threshold voltage Vth of the first transistor T1. In other words, a potential of the third electrode of the first transistor T1 may be the compensating voltage "Di - Vth". The fourth active period AP4 may overlap with the second active period AP2. The duration of the second active period AP2 may be longer than the duration of the fourth active period AP4.

The first driving voltage ELVDD and the compensating voltage "Di-Vth" may be applied at the first and second terminals of the capacitor Cst, and charges corresponding to the difference in voltage between the opposite terminals may be stored in the capacitor Cst. In this case, a high-level period of the j-th compensating scan signal SCj may be referred to as a "compensation period" of the pixel PXij.

Meanwhile, the j-th black scan signal SBj is activated within the second active period AP2 of the j-th compensating scan signal SCj. During an active period AP3 (hereinafter, referred to as a "third active period), the j-th black scan signal SBj has a low level. During the third active period AP3, the seventh transistor T7 is turned on by receiving the j-th black scan signal SBj, which has the low level, applied through the j-th black scan line SBLj. A portion of the driving current Id may be drained through the seventh transistor T7 while functioning as the bypass current Ibp by the seventh transistor T7. The third active period AP3 may overlap with the second active period AP2. The duration of the second active period AP2 may be longer than the duration of the third active period AP3. The third active period AP3 may precede the fourth active period AP4 and may be in the non-overlapping state with the fourth active period AP4.

Even if the minimum driving current of the first transistor T1 flows as the driving current Id such that the pixel PXij displays a black image, when the light emitting element ED emits light, it is difficult for the pixel PXij to normally display the black image. Therefore, according to some embodiments of the present disclosure, the seventh transistor T7 in the pixel PXij may distribute a portion of the minimum driving current of the first transistor T1, which serves as the bypass current Ibp, to a current path other than a current path toward the light emitting element ED. In this case, the minimum driving current of the first transistor T1 may refer to a current flowing through the first transistor T1, under the condition that the first transistor T1 is turned off as the gate-source voltage Vgs of the first transistor T1 is less than the threshold voltage Vth. As the minimum driving current (for example, a current of 10 pA or less) flowing to the first transistor T1 is transmitted to the light emitting element ED under the condition that the first transistor T1 is turned off, an image having a black grayscale is displayed. When the pixel PXij displays the black image, the influence of the bypass current Ibp is relatively greatly exerted on the minimum driving current. To the contrary, when an image, such as a normal image or a white image, is displayed, the influence of the bypass current Ibp is rarely exerted on the driving current Id. Accordingly, to display the black image, a current (that is, a light emitting current (led)) reduced by the quantity of the bypass current Ibp, which flows out of the seventh transistor T7, from the driving current Id is applied to the light emitting element ED to firmly express the black image. Accordingly, the pixel PXij may exactly implement the black grayscale image using the seventh transistor T7. Accordingly, the contrast ratio may be relatively improved.

Next, the j-th light emitting control signal EMj applied from the j-th light emitting control line EMLj is shifted from the high level to the low level. The fifth and sixth transistors T5 and T6 are turned on by the j-th light emitting control signal EMj having the low level. In this case, the driving current Id is generated based on a difference between the voltage of the third electrode of the first transistor T1 and the first driving voltage ELVDD. The driving current Id is applied to the light emitting element ED through the sixth transistor T6, such that the light emitting current led flows through the light emitting element ED.

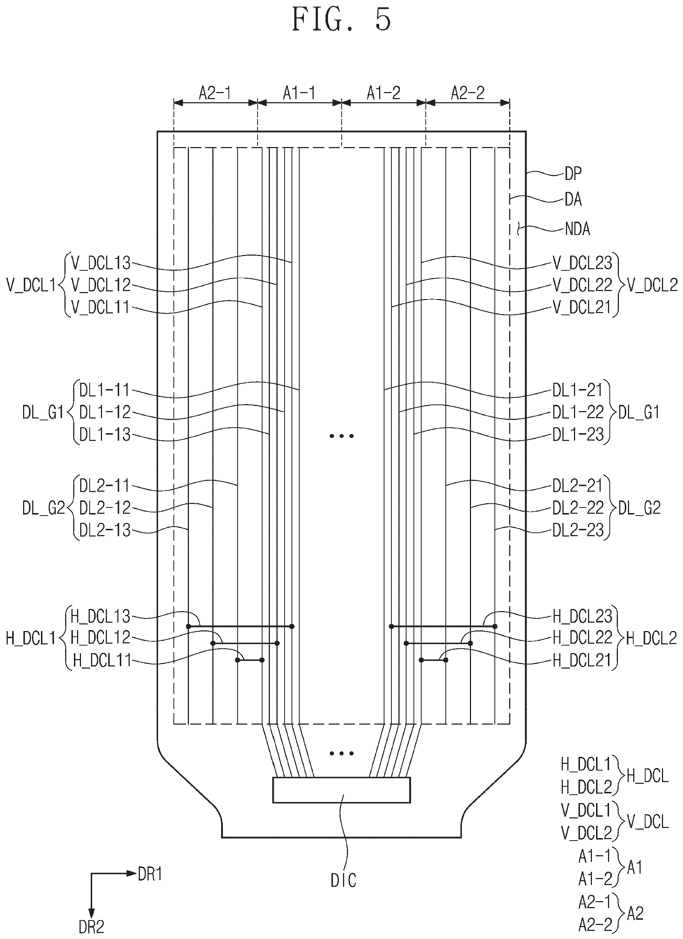

FIG. 5 is a plan view of a display panel according to some embodiments of the present disclosure. In this case, for the convenience of explanation, the scan lines and the light emitting control lines are omitted in FIG. 5, and only data lines are illustrated in FIG. 5.

Referring to FIG. 5, the display panel DP includes the display region DA and the non-display region NDA. The plurality of pixels PX (see FIG. 3) are located in the display region DA. The driving chip DIC is mounted in the non-display region NDA.

The data lines DL1 to DLm (see FIG. 3) are connected to the plurality of pixels PX in the display region DA, and connected to the driving chip DIC in the non-display region NDA.

The data lines DL1 to DLm may be grouped into a first group and a second group. The first group includes a plurality of first data lines DL_G1, and the second group includes a plurality of second data lines DL_G2. The plurality of first data lines DL_G1 are arranged in the first direction DR1, and the plurality of second data lines DL_G2 are arranged in the first direction DR1. The plurality of first data lines DL_G1 are spaced apart from the plurality of second data lines DL_G2 in the first direction DR1.

The plurality of first data lines DL_G1 are connected to the pixel driving circuit P_PD for a first group of pixels of the plurality of pixels PX, and the plurality of second data lines DL_G2 are connected to the pixel driving circuit P_PD for a second group of pixels of the plurality of pixels PX. The first group of pixels and the first data lines DL_G1 are located in a first region A1, and the second group of pixels and the second data lines DL_G2 are located in a second region A2. The first region A1 includes a (1-1)-th region A1-1 defined at a first side based on a central line of the display panel DP parallel to the second direction DR2 and a (1-2)-th region A1-2 defined at a second side based on the central line. The second region A2 includes a (2-1)-th region A2-1 interposed between the (1-1)-th region A1-1 and the non-display region NDA and a (2-2)-th region A2-2 interposed between the (1-2)-th region A1-2 and the non-display region NDA.

The plurality of first data lines DL_G1 include (1-1)-th data lines DL1-11 to DL1-13 located in the (1-1)-th region A1-1 and (1-2)-th data lines DL1-21 to DL1-23 located in the (1-2)-th region A1-2. The plurality of second data lines DL_G2 include (2-1)-th data lines DL2-11 to DL2-13 located in the (2-1)-th region A2-1 and (2-2)-th data lines DL2-21 to DL2-23 located in the (2-2)-th region A2-2.

The (1-1)-th data lines DL1-11 to DL1-13 and the (1-2)-th data lines DL1-21 to DL1-23 are connected to the driving chip DIC. Although FIG. 5 illustrates that the (1-1)-th data lines DL1-11 to DL1-13 and the (1-2)-th data lines DL1-21 to DL1-23 are connected to the same driving chip DIC, embodiments according to the present disclosure are not limited thereto. For example, the (1-1)-th data lines DL1-11 to DL1-13 and the (1-2)-th data lines DL1-21 to DL1-23 may be connected to mutually different diving chips, respectively.

The display panel DP further includes data connecting lines to connect the second data lines DL_G2 to the driving chip DIC. The data connecting lines include a plurality of vertical connecting lines V_DCL extending in the second direction DR2 along the first data lines DL_G1 and a plurality of horizontal connecting lines H_DCL extending in the first direction DR1.

The plurality of horizontal connecting lines H_DCL include first horizontal connecting lines H_DCL11 to H_DCL13 and second horizontal connecting lines H_DCL21 to H_DCL23. The first horizontal connecting lines H_DCL11 to H_DCL13 are connected to the (2-1)-th data lines DL2-11 to DL2-13, and the second horizontal connecting lines H_DCL21 to H_DCL23 are connected to the (2-2)-th data lines DL2-21 to DL2-23. The plurality of vertical connecting lines V_DCL include first vertical connecting lines V_DCL11 to V_DCL13 and second vertical connecting lines V_DCL21 to V_DCL23. The first vertical connecting lines V_DCL11 to V_DCL13 are connected to the first horizontal connecting lines H_DCL11 to H_DCL13, and the second vertical connecting lines V_DCL21 to V_DCL23 are connected to the second horizontal connecting lines H_DCL21 to H_DCL23.

Accordingly, the first vertical connecting lines V_DCL11 to V_DCL13 are electrically connected to the (2-1)-th data lines DL2-11 to DL2-13 through the first horizontal connecting lines H_DCL11 to H_DCL13. The second vertical connecting lines V_DCL21 to V_DCL23 are electrically connected to the (2-2)-th data lines DL2-21 to DL2-23 through the second horizontal connecting lines H_DCL21 to H_DCL23.

The first vertical connecting lines V_DCL11 to V_DCL13 and the (1-1)-th data lines DL1-11 to DL1-13 are alternately and repeatedly arranged in the (1-1)-th region A1-1. The second vertical connecting lines V_DCL21 to V_DCL23 and the (1-2)-th data lines DL1-21 to DL1-23 are alternately and repeatedly arranged in the (1-2)-th region A1-2.

Some of the vertical connecting lines V_DCL and the plurality of horizontal connecting lines H_DCL may be located in the display region DA. In other words, some of data lines to connect the second data lines DL_G2 to the driving chip DIC are located in the display region DA. Accordingly, an area of a region occupied by the data connecting lines may be reduced in the non-display region NDA, so the area of the dead space of the display panel DP may be reduced.

FIG. 6 is a cross-sectional view of a display panel according to some embodiments of the present disclosure.

Referring to FIG. 6, the display panel DP may include the base layer BL, the circuit layer DP_CL, and the element layer DP_ED.

The base layer BL may include a synthetic resin layer. The synthetic resin layer may include a thermosetting resin material. In particular, the synthetic resin layer may be a polyimide-based resin layer, and the material thereof is not particularly limited. The synthetic resin layer may include at least one of an acrylic resin, a methacrylic resin, a polyisoprene resin, a vinyl resin, an epoxy resin, an urethane resin, a cellulose resin, a siloxane resin, a polyamide resin, or a perylene resin. Besides, the base layer may include a glass substrate, a metal substrate, or an organic/inorganic composite material substrate.

At least one inorganic layer is formed on a top surface of the base layer BL. The inorganic layer may include at least one of aluminum oxide, titanium oxide, silicon oxide, silicon oxy nitride, zirconium oxide, or hafnium oxide. The inorganic layer may have a multi-layer structure. The multiple inorganic layers may constitute a barrier layer BRL and/or a buffer layer BFL, which will be described later. The barrier layer BRL and the buffer layer BFL may be arranged selectively.

The circuit layer DP_CL may include a barrier layer BRL and/or a buffer layer BFL. The barrier layer BRL prevents or reduces instances of foreign substances being introduced from the outside. The barrier layer BRL may include a silicon oxide layer and a silicon nitride layer. The silicon oxide layer may include a plurality of silicon oxide layers and the silicon nitride layer may include a plurality of silicon nitride layers, and the silicon oxide layers and the silicon nitride layers may be alternately stacked.

The buffer layer BFL may be located on the barrier layer BRL. The buffer layer BFL relatively improves a bonding force between the base layer BL and a semiconductor pattern and/or a conductive pattern. The buffer layer BFL may include a silicon oxide layer and a silicon nitride layer. The silicon oxide layer and the silicon nitride layer may be alternately stacked.

A semiconductor pattern is located on the buffer layer BFL. Hereinafter, a semiconductor pattern directly located on the buffer layer BFL is defined as a first semiconductor pattern. The first semiconductor pattern may include a silicon semiconductor. The first semiconductor pattern may include poly silicon. However, embodiments according to the present disclosure are not limited thereto. For example, the first semiconductor pattern may include amorphous silicon.

Although FIG. 6 illustrates a portion of the first semiconductor pattern, the first semiconductor pattern may be additionally located in another region of the pixels PXij (see FIG. 4A). The first semiconductor pattern may have an electrical property varying depending on the doping state. The first semiconductor pattern may include a doping region and a non-doping region. The doping region may be doped with the N-type dopant or the P-type dopant. A transistor in a P type may include a doping region doped with the P-type dopant, and a transistor in an N type may be a doping region doped with the N-type dopant.

The doping region is greater than the non-doping region in conductivity, and actually serves as an electrode or a signal line. The non-doping region may actually correspond to an active (or a channel) of the transistor. In other words, a portion of the first semiconductor pattern may be the active of the transistor, another portion thereof may be a source or drain of the transistor, and still another portion thereof may be a connecting signal line (or connecting electrode).

As illustrated in FIG. 6, a first electrode S1, a channel part CH1, and a second electrode D1 of the first transistor T1 are formed from the first semiconductor pattern. The first electrode S1 and the second electrode D1 of the first transistor T1 may extend in directions opposite to each other from the channel part CH1.

A portion of a connecting signal line CSL formed from the semiconductor pattern is illustrated in FIG. 6. According to some embodiments, the connecting signal line CSL may be electrically connected to the second electrode of the sixth transistor T6 (see FIG. 4A) when viewed in a plan view.

The first insulating layer 10 is located on the buffer layer BFL. The first insulating layer 10 may overlap with the pixels PX (see FIG. 3) in common to cover the first semiconductor pattern layer. The first insulating layer 10 may be an inorganic layer and/or an organic layer and may have a single-layer or multi-layer structure. The first insulating layer 10 may include at least one of an aluminum oxide, a titanium oxide, a silicon oxide, a silicon oxynitride, a zirconium oxide, or a hafnium oxide. According to some embodiments, the first insulating layer 10 may be a single silicon oxide layer. In addition to the first insulating layer 10, the insulating layer of the circuit layer DP_CL, which is to be described below, may be an inorganic layer and/or an organic layer, and may have a single layer structure or a multi-layer structure. The inorganic layer may include at least one of the above-described materials.

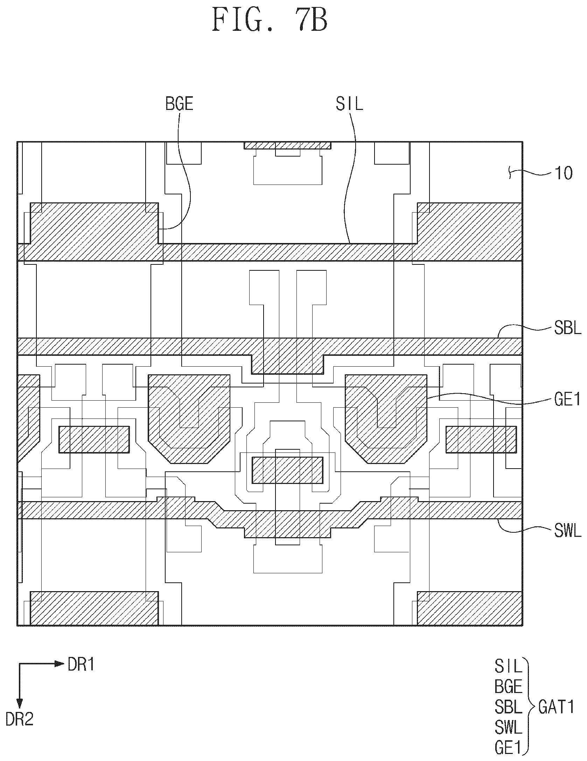

A third electrode G1 of the first transistor T1 is located on the first insulating layer 10. The third electrode G1 may be a portion of the first gate pattern layer GAT1 (see FIG. 7B). The third electrode G1 of the first transistor T1 overlaps with the channel part CH1 of the first transistor T1. In the process of doping the first semiconductor pattern, the third electrode G1 of the first transistor T1 may serve as a mask.

A second insulating layer 20 is located on the first insulating layer 10 to cover the third electrode G1. The second insulating layer 20 may overlap with the plurality of pixels PX in common. The second insulating layer 20 may be an inorganic layer and/or an organic layer and may have a single-layer or multi-layer structure. According to some embodiments, the second insulating layer 20 may be a single silicon oxide layer.

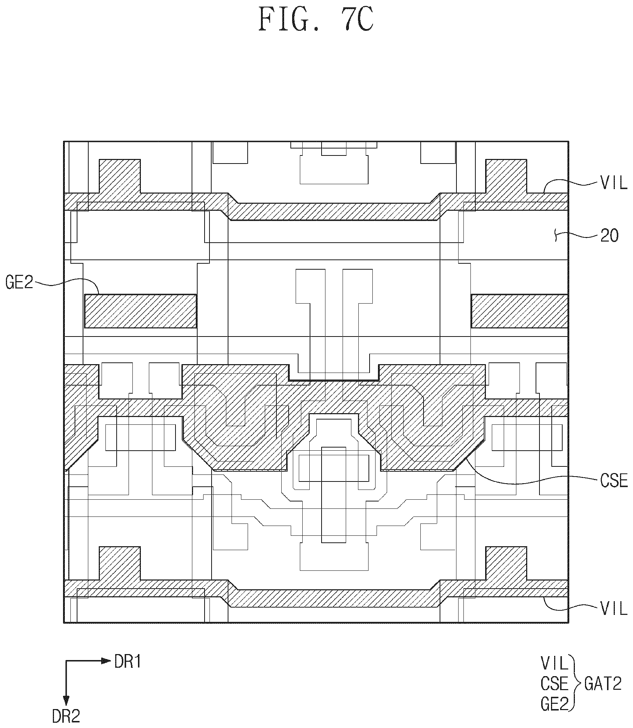

An upper electrode UE and a lower electrode BE may be located on the second insulating layer 20. The upper electrode UE may overlap with the third electrode G1. The lower electrode BE may overlap with a second semiconductor pattern of a fourth transistor T4 to be described later. The lower electrode BE may be referred to as a bottom gate of the fourth transistor T4. The upper electrode UE and the lower electrode BE may be portions of a second gate pattern layer GAT2 (see FIG. 7C). A portion of the third electrode G1 and the upper electrode UE overlapping with the portion of the third electrode G1 may define the capacitor Cst (see FIG. 4A). According to some embodiments of the present disclosure, the upper electrode UE may be omitted. Although FIG. 6 illustrates the structure in which the lower electrode BE and the upper electrode UE are located on the same layer, embodiments according to the present disclosure are not limited thereto. Alternatively, the lower electrode BE may be a portion of the first gate pattern layer GAT1 (see FIG. 7B). In this case, the lower electrode BE and the third electrode G1 of the first transistor T1 may be located on the same layer.

According to some embodiments of the present disclosure, the second insulating layer 20 may be substituted to an insulating pattern. The upper electrode UE and the lower electrode BE are located on the insulating pattern. The upper electrode UE and the lower electrode BE may serve as a mask for forming the insulating pattern from the second insulating layer 20.

A third insulating layer 30 is located on the second insulating layer 20 to cover the upper electrode UE and the lower electrode BE. According to some embodiments, the third insulating layer 30 may be a single silicon oxide layer. A semiconductor pattern is located on the third insulating layer 30. Hereinafter, a semiconductor pattern directly located on the third insulating layer 30 may be defined as a second semiconductor pattern. The second semiconductor pattern may include a metal oxide layer. The oxide semiconductor may include a crystalline or amorphous oxide semiconductor. For example, the oxide semiconductor may include metal oxide of zinc (Zn), indium (In), gallium (Ga), tin (Sn), or titanium (Ti) or a mixture of a metal, such as zinc (Zn), indium (In), gallium (Ga), tin (Sn), or titanium (Ti), and an oxide thereof. The oxide semiconductor may include indium-tin oxide (ITO), indium-gallium-zinc oxide (IGZO), zinc oxide (ZnO), indium-zinc oxide (IZO), indium oxide (InO), titanium oxide (TiO), indium-zinc-tin oxide (IZTO), or zinc-tin oxide (ZTO).

Although FIG. 6 illustrates a portion of the second semiconductor pattern, the second semiconductor pattern may be additionally located in another region of the pixels PXij. The second semiconductor pattern may include a plurality of regions that are distinguished depending on whether the metal oxide is reduced. A region (hereinafter referred to as a "reduction region") in which the metal oxide is reduced has higher conductivity than a region (hereinafter referred to as a "non-reduction region") in which the metal oxide is not reduced. The reduction region has the role of an electrode or a signal line. The non-reduction region corresponds to a channel portion of a transistor. In other words, the portion of the second semiconductor pattern may be a channel portion of a transistor, and another portion thereof may be a first electrode or a second electrode of the transistor.

The circuit layer DP_CL may further include a portion of the semiconductor pattern of the pixel driving circuit P_PD (see FIG. 4A). For convenience of explanation, the fourth transistor T4 of the semiconductor pattern of the pixel driving circuit P_PD is illustrated. A first electrode S4, a channel part CH4, and a second electrode D4 of the fourth transistor T4 are formed from the second semiconductor pattern. According to some embodiments of the present disclosure, the second semiconductor pattern may include a metal oxide. The first electrode S4 and the second electrode D4 include metal reduced from a metal oxide semiconductor. The first electrode S4 and the second electrode D4 may include a metal layer having a specific thickness from a top surface of the second semiconductor pattern, and may include the reduced metal.

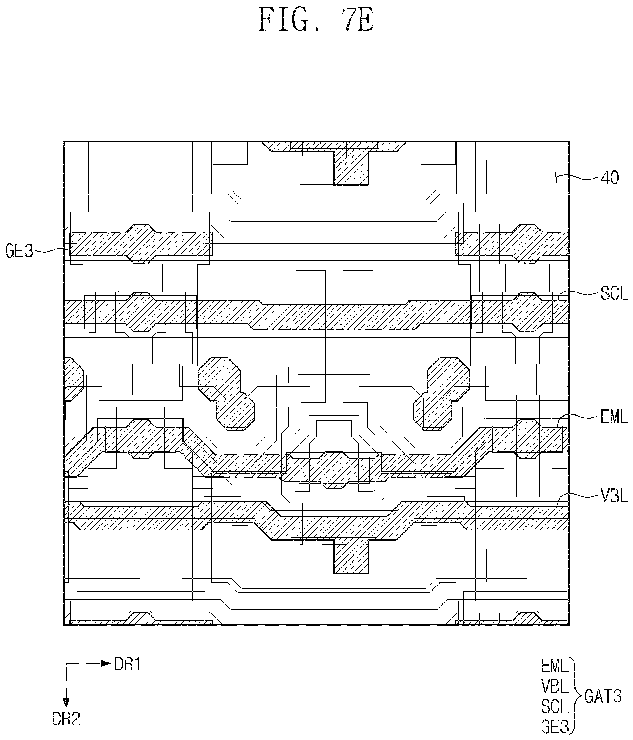

The fourth insulating layer 40 is arranged to cover the first electrode S4, the channel part CH4, and the second electrode D4 of the fourth transistor T4. A third electrode G4 of the fourth transistor T4 is located on the fourth insulating layer 40. According to some embodiments, the third electrode G4 of the fourth transistor T4 may be a portion of a third gate pattern layer GAT3 (see FIG. 7E). The third electrode G4 of the fourth transistor T4 may be referred to as a top gate. The third electrode G4 of the fourth transistor T4 overlaps with the channel part CH4 of the fourth transistor T4. The third electrode G4 of the fourth transistor T4 may overlap with the lower electrode BE, when viewed in a plan view, and may be connected to the lower electrode BE through a contact hole formed through the third and fourth insulating layers 30 and 40. In other words, the third electrode G4 of the fourth transistor T4 may be electrically connected to the lower electrode BE.

A fifth insulating layer 50 is located on the fourth insulating layer 40 to cover the third electrode G4 of the fourth transistor T4. According to some embodiments, the fifth insulating layer 50 may include a silicon oxide layer and a silicon nitride layer. The fifth insulating layer 50 may include a plurality of silicon oxy nitride layers and silicon nitride layers alternately stacked one another.

At least one insulating layer is further located on the fifth insulating layer 50. According to some embodiments, a sixth insulating layer 60 may be located on the fifth insulating layer 50. The sixth insulating layer 60 may be an organic layer, and may have a single-layer structure or a multi-layer structure. The sixth insulating layer 60 may be a single-layer polyimide-based resin layer. However, embodiments according to the present disclosure are not limited thereto. For example, the sixth insulating layer 60 may include at least one of acrylic resin, methacrylic resin, polyisoprene resin, vinyl resin, epoxy resin, urethane-based resin, cellulosic resin, siloxane-based resin, polyamide resin, or perylene-based resin.

A first connecting electrode CNE10 may be located on the fifth insulating layer 50. The first connecting electrode CNE10 is connected to the connecting signal line CSL through a first contact hole CH1 formed through the first to fifth insulating layers 10, 20, 30, 40, and 50. A second connecting electrode CNE20 may be connected to the first connecting electrode CNE10 through a second contact hole CH2 formed through the sixth insulating layer 60.

The first connecting electrode CNE10 may be a portion of a first data metal pattern, and the second connecting electrode CNE20 may be a portion of a second data metal pattern.

The horizontal connecting lines H_DCL (see FIG. 5) may be located on a layer (that is, the fifth insulating layer 50) the same as a layer for the first connecting electrode CNE10. However, embodiments according to the present disclosure are not limited thereto. The horizontal connecting lines H_DCL may be located on a layer (that is, the first insulating layer 10) the same as a layer for the third electrode G1 of the first transistor T1. The vertical connecting lines V_DCL (see FIG. 5), and the first and second data lines DL_G1 and DL_G2 (see FIG. 5) may be located on a layer (that is, the sixth insulating layer 60) the same as a layer for the second connecting electrode CNE20.

A seventh insulating layer 70 is further located on the sixth insulating layer 60 to cover the vertical connecting lines V_DCL (see FIG. 5), the first and second data lines DL_G1 and DL_G2, and the second connecting electrode CNE20. A third contact hole CH3 may be provided in the seventh insulating layer 70 to partially expose the second connecting electrode CNE20.

The element layer DP_ED is located on the circuit layer DP_CL. The element layer DP_ED may include an anode electrode AE of the light emitting element ED (see FIG. 4A). As illustrated in FIG. 6, the anode electrode AE of the light emitting element ED may be connected to the second connecting electrode CNE20 through a third contact hole CH3 formed through the seventh insulating layer 70. Although FIG. 6 illustrates that the anode electrode AE is directly connected to the second connecting electrode CNE20, embodiments according to the present disclosure are not limited thereto. Alternatively, the circuit layer DP_CL may further include a bridge electrode to connect the anode electrode AE to the second connecting electrode CNE20.

The element layer DP_ED further includes a pixel defining layer PDL located on the circuit layer DP_CL. The pixel defining layer PDL may include an opening OP that is defined to correspond to the light emitting element ED. The opening OP exposes at least a portion of the anode electrode AE of the light emitting element ED. The opening OP of the pixel defining layer PDL may define a light emitting region PXA. For example, the plurality of pixels PX (see FIG. 3) may be arranged in a specific rule when viewed in a plan view of the display panel DP (see FIG. 3). A region in which the plurality of pixels PX are arranged may be defined as a pixel region, and one pixel region may include a light emitting region PXA and a non-light emitting region NPXA adjacent to the light emitting region PXA. The non-light emitting region NPXA may surround the light emitting region PXA.

A light emitting layer EL is arranged to correspond to the opening OP defined in the pixel defining layer PDL. According to some embodiments, although the patterned light emitting layer EL is illustrated, embodiments according to the present disclosure are not limited thereto. Alternatively, a common light emitting layer may be located in the plurality of pixels PX in common. In this case, the common light emitting layer may generate a white light or a blue light. A cathode electrode CE is located on the light emitting layer EL. The cathode electrode CE is located in the plurality of pixels PX in common.

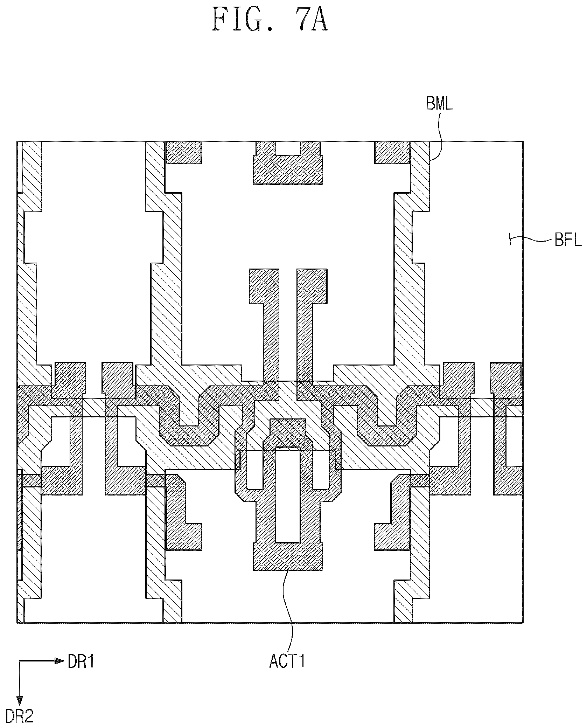

FIGS. 7A to 7F are plan views illustrating the layout of each layer included in a circuit layer according to some embodiments of the present disclosure.

Referring to FIGS. 7A, a light blocking pattern layer BML may be formed on the buffer layer BFL. The light blocking pattern layer BML may be a conductive pattern having a light blocking function. The light blocking pattern layer BML may be located under at least one of transistors T1 to T8 (see FIG. 4A) provided in each pixel driving circuit P_PD, to block light from the outside to the transistors T1 to T8.

A first semiconductor pattern layer ACT1 may be located on the light blocking pattern layer BML and the buffer layer BFL. The first semiconductor pattern layer ACT1 may overlap with the light blocking pattern layer BML on the buffer layer BFL. The first semiconductor pattern layer ACT1 may include a silicon semiconductor. For example, the silicon semiconductor may include amorphous silicon, or polycrystalline silicon. For example, the first semiconductor pattern layer ACT1 may include low-temperature polycrystalline silicon (LTPS).

The first semiconductor pattern layer ACT1 include a first semiconductor pattern of some transistors T1, T2, and T5 to T8 included in the pixel driving circuit P_PD. The first semiconductor pattern layer ACT1 and the light blocking pattern layer BML are covered by the first insulating layer 10.

Referring to FIG. 7B, the first gate pattern layer GAT1 may be located on the first insulating layer 10. The first gate pattern layer GAT1 may include metal, an alloy, a conductive metal oxide, or a transparent conductive material. For example, the first gate pattern layer GAT1 may include silver (Ag), the alloy containing silver (Ag), molybdenum (Mo), the alloy containing molybdenum (Mo), aluminum (Al), the alloy containing aluminum (Al), an aluminum nitride (AIN), tungsten (W), a tungsten nitride (WN), copper (Cu), indium tin oxide (ITO), or indium zinc oxide (IZO), but embodiments according to the present disclosure are not limited thereto.

The first gate pattern layer GAT1 may include a first gate wire SIL, a second gate wire SBL, a third gate wire SWL, a first gate electrode GE1, and a bottom gate electrode BGE.

Each of the first to third gate wires SIL, SBL, and SWL may extend in the first direction DR1. The first gate wire SIL corresponds to the j-th initializing scan line SILj of FIG. 4A. For example, the j-th initializing scan signal SIj (see FIG. 4A) may be applied to the first gate wire SIL. The bottom gate electrode BGE extends from the first gate wire SIL. The bottom gate electrode BGE may correspond to the lower electrode BE (that is, referred to as a "bottom gate") illustrated in FIG. 6.

The second gate wire SBL corresponds to the j-th black scan line SBLj of FIG. 4A. For example, the j-th black scan signal SBj (see FIG. 4A) may be applied to the second gate wire SBL. The second gate wire SBL may constitute the seventh transistor T7 of FIG. 4A together with the first semiconductor pattern layer ACT1.

The third gate wire SWL corresponds to the j-th write scan line SWLj of FIG. 4A. For example, the j-th write scan signal SWj (see FIG. 4A) may be applied to the third gate wire SWL. The third gate wire SWL may constitute the second transistor T2 of FIG. 4A, together with the first semiconductor pattern layer ACT1.

The first gate electrode GE1 may be located in the shape of an island. The first gate electrode GE1 may constitute the first transistor T1 of FIG. 4A, together with the first semiconductor pattern layer ACT1. The first gate electrode GE1 may correspond to the third electrode G1 of the first transistor T1 illustrated in FIG. 6.

Referring to FIGS. 7B and 7C, the second insulating layer 20 may be located on the first insulating layer 10 while covering the first gate pattern layer GAT1. The second gate pattern layer GAT2 may be located on the second insulating layer 20. The second gate pattern layer GAT2 may include metal, an alloy, a conductive metal oxide, or a transparent conductive material.

The second gate pattern layer GAT2 may include a fourth gate wire VIL, a capacitor electrode CSE, and a second gate electrode GE2.

The fourth gate wire VIL may extend in the first direction DR1. The fourth gate wire VIL corresponds to the first initializing voltage line VIL (see FIG. 4A). The first initializing voltage Vint may be applied to the fourth gate wire VIL.

The capacitor electrode CSE may overlap with the first gate electrode GE1, and may be arranged in the shape of an island. The capacitor electrode CSE may constitute the capacitor Cst (see FIG. 4A) together with the first gate electrode GE1. The capacitor electrode CSE may correspond to the upper electrode UE illustrated in FIG. 6. According to some embodiments of the present disclosure, the plurality of capacitor electrodes CSE may be connected to each other in the first direction DR1.

The second gate electrode GE2 may correspond to the lower electrode facing the second semiconductor pattern of the third transistor T3 of FIG. 4A.

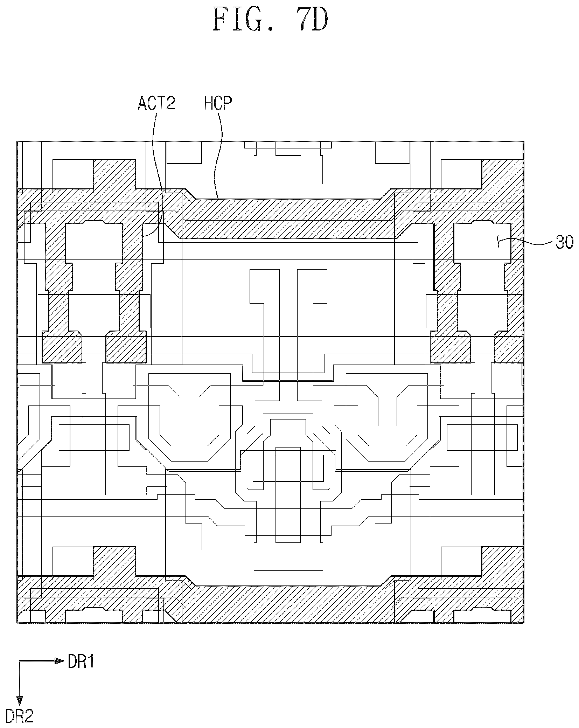

Referring to FIGS. 7C and 7D, the third insulating layer 30 may be located on the second insulating layer 20 while covering the second gate pattern layer GAT2. Second semiconductor pattern layers ACT2 and HCP may be located on the third insulating layer 30. The second semiconductor pattern layers ACT2 and HCP may include a plurality of oxide semiconductor patterns ACT2 and a connecting pattern HCP. The second semiconductor pattern layers ACT2 and HCP may be located in a layer different from a layer for the first semiconductor pattern layer ACT1, and may not overlap with the first semiconductor pattern layer ACT1.

The oxide semiconductor patterns ACT2 may include a second semiconductor pattern of some transistors T3 and T4 included in the pixel driving circuit P_PD. According to some embodiments of the present disclosure, the oxide semiconductor patterns ACT2 may have the shape extending in the second direction DR2. The oxide semiconductor patterns ACT2 may be connected to each other through the connecting pattern HCP. The connecting pattern HCP may extend in the first direction DR1.

Referring to FIGS. 7D and 7E, the fourth insulating layer 40 may be located on the third insulating layer 30 while covering second semiconductor pattern layers ACT2 and HCP. The third gate pattern layer GAT3 may be located on the fourth insulating layer 40. The third gate pattern layer GAT3 may include metal, an alloy, a conductive metal oxide, or a transparent conductive material.

The third gate pattern layer GAT3 may include a fifth gate wire SCL, a sixth gate wire EML, a seventh gate wire VBL, and a third gate electrode GE3.

Each of the fifth to seventh gate wires SCL, EML, and VBL may extend in the first direction DR1. The fifth gate wire SCL corresponds to the j-th compensating scan line SCLj of FIG. 4A. Accordingly, the j-th compensating scan signal SCj may be applied to the fifth gate wire SCL. The fifth gate wire SCL may overlap with the oxide semiconductor pattern ACT2. The fifth gate wire SCL may constitute the third transistor T3 of FIG. 4A, together with the oxide semiconductor pattern ACT2.

The third gate electrode GE3 may overlap with the oxide semiconductor pattern ACT2, when viewed in a plan view. The third gate electrode GE3 may correspond to the third electrode G4 (that is, referred to as a "top gate") of the fourth transistor T4 illustrated in FIG. 6. The third gate electrode GE3 may overlap with the bottom gate electrode BGE illustrated in FIG. 7B when viewed in a plan view.

The sixth gate wire EML corresponds to the j-th light emitting control line EMLj illustrated in FIG. 4A. Accordingly, the j-th light emitting control signal EMj may be applied to the sixth gate wire EML. The sixth gate wire EML may constitute the fifth and sixth transistors T5 and T6 illustrated FIG. 4A, together with the first semiconductor pattern layer ACT1.

A seventh gate wire VBL corresponds to the bias voltage line VBL illustrated in FIG. 4A. The bias voltage Vbias may be applied to the seventh gate wire VBL. The seventh gate wire VBL may constitute the eighth transistor T8 illustrated in FIG. 4A, together with the first semiconductor pattern layer ACT1.

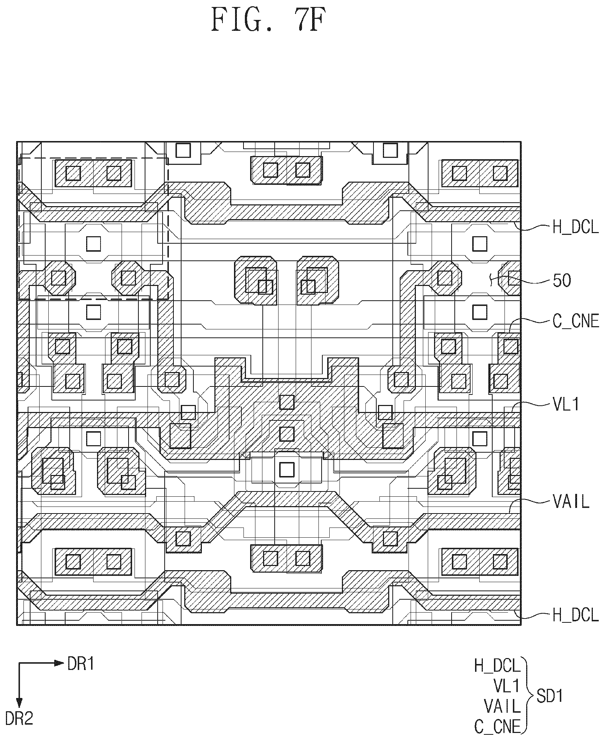

Referring to FIGS. 7E and 7F, the fifth insulating layer 50 may be located on the fourth insulating layer 40 while covering the third gate pattern layer GAT3. A first data pattern layer SD1 may be located on the fifth insulating layer 50. The first data pattern layer SD1 may include metal, an alloy, a conductive metal oxide, or a transparent conductive material.

The first data pattern layer SD1 may include a horizontal connecting line H_DCL, a first driving voltage line VL1, a second initializing voltage line VAIL, and a plurality of connecting electrode pattern C_CNE.

The horizontal connecting line H_DCL, the first driving voltage line VL1, and the second initializing voltage line VAIL may extend in the first direction DR1. The horizontal connecting line H_DCL may correspond to the horizontal connecting line H_DCL illustrated in FIG. 5. The horizontal connecting line H_DCL may be connected to a relevant data line and a relevant vertical connecting line.

The first driving voltage line VL1 may correspond to the first driving voltage line VL1 illustrated in FIG. 4A, and the first driving voltage ELVDD (see FIG. 4A) may be applied to the first driving voltage line VL1. The first driving voltage line VL1 may be connected to the capacitor electrode CSE.

The second initializing voltage line VAIL may correspond to the second initializing voltage line VAIL illustrated in FIG. 4A, and the second initializing voltage Vaint (see FIG. 4A) may be applied to the second initializing voltage line VAIL.

The plurality of connecting electrode patterns C_CNE may make contact with one of the first and second semiconductor patterns. The plurality of connecting electrode patterns C_CNE may electrically connect one of the first and second semiconductor patterns to different wires or different lines. The plurality of connecting electrode patterns C_CNE may make contact with one of the first and second semiconductor patterns through a contact part. The plurality of connecting electrode patterns C_CNE may include a first connecting electrode CNE10 illustrated in FIG. 6.

The sixth insulating layer 60 (see FIG. 6) may cover the first data pattern layer SD1, and may be located on the fifth insulating layer 50. The second data pattern layer may be located on the sixth insulating layer 60. The second data pattern layer may include, for example, metal, an alloy, a conductive metal oxide, or a transparent conductive material. The second data pattern layer may include the data lines DL1 to DLm (see FIG. 3), the vertical connecting line V_DCL (see FIG. 5), and the second connecting electrode CNE20 (see FIG. 6).

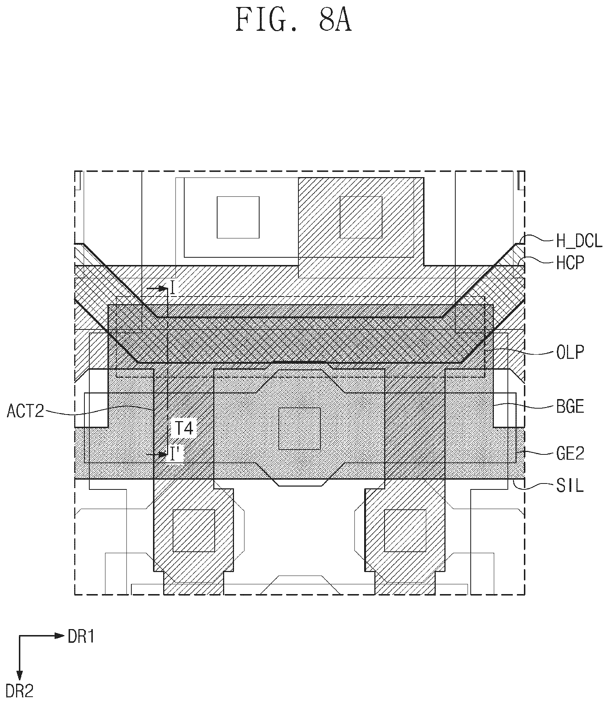

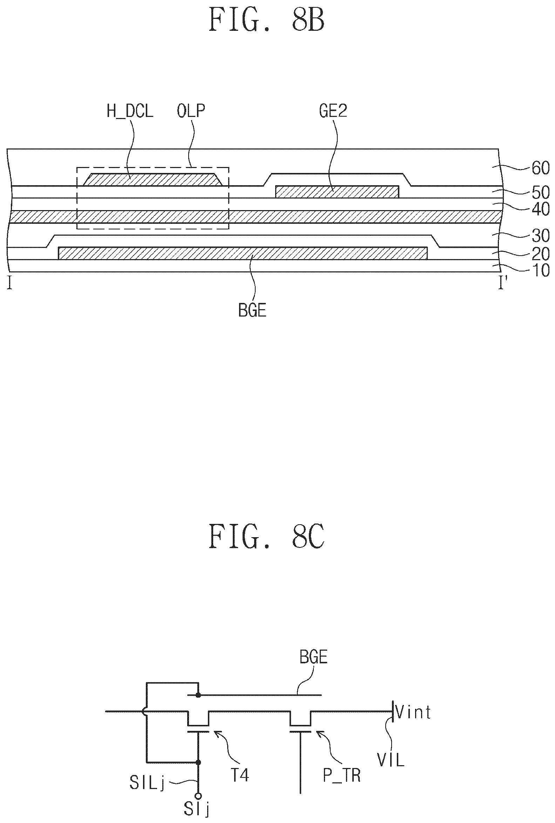

FIG. 8A is an enlarged plan view illustrating a portion of a display panel, which is enlarged, according to some embodiments of the present disclosure, FIG. 8B is a cross-sectional view taken along the line I-I' illustrated in FIG. 8A, and FIG. 8C is a circuit diagram illustrating the relationship between the fourth transistor and the parasitic transistor illustrated in FIG. 8A.

Referring to FIGS. 8A to 8C, the bottom gate electrode BGE may extend from the first gate wire SIL, and may overlap with the oxide semiconductor pattern ACT2 when viewed in a plan view. According to some embodiments of the present disclosure, the connecting pattern HCP extends in the first direction DR1 to connect the oxide semiconductor patterns ACT2, which are arranged in the first direction DR1, to each other. The connecting pattern HCP may extend from the oxide semiconductor patterns ACT2 and may have the shape integrated with the oxide semiconductor patterns ACT2. The connecting pattern HCP may partially overlap with the horizontal connecting line H_DCL to form an overlap part OLP, when viewed in a plan view. The bottom gate electrode BGE may extend to overlap with the connecting pattern HCP and the horizontal connecting line H_DCL. The bottom gate electrode BGE may extend to overlap with the connecting pattern HCP and the overlap part OLP of the horizontal connecting line H_DCL when viewed in a plan view. The bottom gate electrode BGE may correspond to the lower electrode BE (that is, referred to as a "bottom gate") of the fourth transistor T4 illustrated in FIG. 6.

The bottom gate electrode BGE may receive the j-th initializing scan signal Slj (see FIG. 4B) through the first gate wire SIL. The j-th initializing scan signal Slj has an active level (for example, the high level) for the first active period AP1 (see FIG. 4B).

A parasitic transistor P_TR may be formed in the overlap part OLP between the connecting pattern HCP and the horizontal connecting line H_DCL. As the parasitic transistor P_TR is turned on/off, the first initializing voltage Vint may not be applied to the fourth transistor T4 normally. In this case, the pixel PXij (see FIG. 4A) may not be initialized normally for the first active period AP1, so the brightness of the pixel PXij may be lowered.

However, when the bottom gate electrode BGE extends to the overlap part OLP, the parasitic transistor P_TR may be on-biased by the bottom gate electrode BGE for the first active period AP1. Accordingly, an amount of current flowing through the parasitic transistor P_TR is increased for the first active period AP1, so the first initializing voltage Vint is applied to the fourth transistor T4 normally for the first active period AP1. In other words, the initializing operation of the pixel PXij may be normally performed for the first active period AP1, thereby preventing or reducing instances of display stains being caused in a portion in which the horizontal connecting line H_DCL is located.

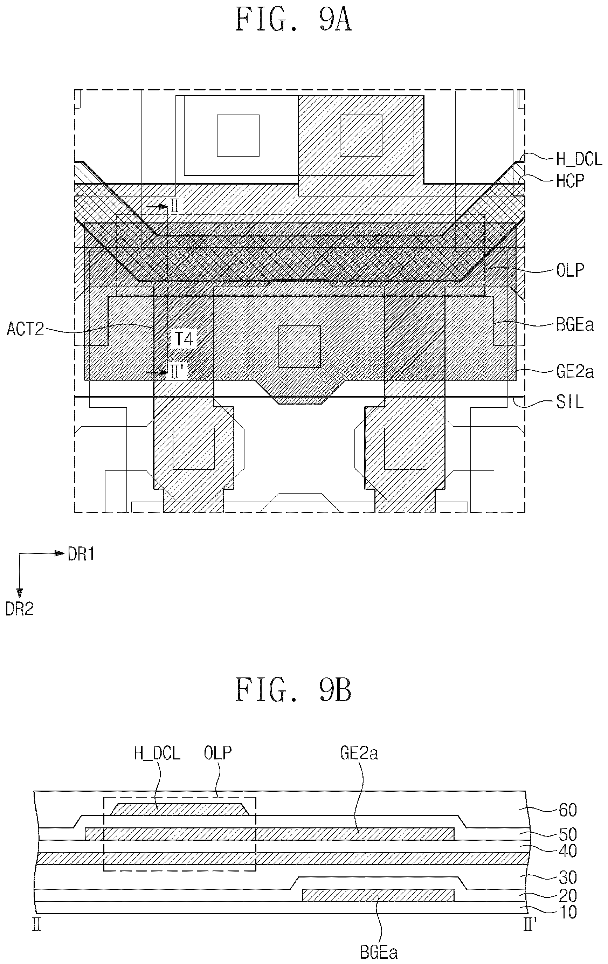

Although FIGS. 8A and 8B illustrate the structure in which the bottom gate electrode BGE overlaps with the overlap part OLP, and the second gate electrode GE2 is in a non-overlap with the overlap part OLP, embodiments according to the present disclosure are not limited thereto. As illustrated in FIG. 9A, the bottom gate electrode BGEa may be in the non-overlap with the overlap part OLP, and the second gate electrode GE2a may overlap with the overlap part OLP.

FIG. 9A is an enlarged plan view illustrating an enlarged portion of a display panel according to some embodiments of the present disclosure. FIG. 9B is a cross-sectional view taken along the line II-II' of FIG. 9A.

Referring to FIGS. 9A and 9B, the second gate electrode GE2a may be electrically connected to the first gate wire SIL and the bottom gate electrode BGEa. The second gate electrode GE2a may correspond to the third electrode G4 of the fourth transistor T4 illustrated in FIG. 6. The second gate electrode GE2a may be referred to as a top gate of the fourth transistor T4. A bottom gate electrode BGEa may overlap with the oxide semiconductor pattern ACT2, and may be in the non-overlapping state with the connecting pattern HCP, when viewed in a plan view. The second gate electrode GE2a overlaps with the oxide semiconductor pattern ACT2, when viewed in a plan view. The second gate electrode GE2a may extend to overlap with the overlap part OLP between the connecting pattern HCP and the horizontal connecting line H_DLC, when viewed in a plan view.

When the second gate electrode GE2a extends until the overlap part OLP, the parasitic transistor P_TR may be on-biased by the second gate electrode GE2a for the first active period AP1. Accordingly, an amount of current flowing through the parasitic transistor P_TR is increased for the first active period AP1, so the first initializing voltage Vint is applied to the fourth transistor T4 normally for the first active period AP1.

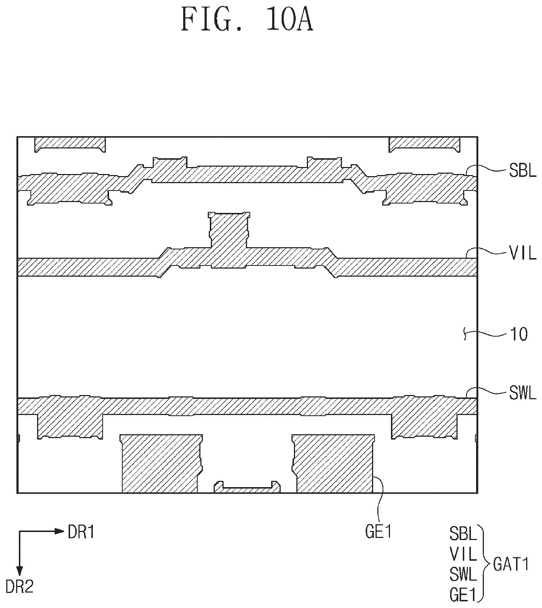

FIGS. 10A to 10E are plan views illustrating the layout of a circuit layer according to some embodiments of the present disclosure.

Referring to FIG. 10A, a first gate pattern layer GAT1 may be located on the first insulating layer 10. The first gate pattern layer GAT1 may include metal, an alloy, a conductive metal oxide, or a transparent conductive material.

The first gate pattern layer GAT1 may include a first gate wire SBL, a second gate wire VIL, a third gate wire SWL, and a first gate electrode GE1.

Each of the first to third gate wires SBL, VIL, and SWL may extend in the first direction DR1. The first gate wire SBL corresponds to the j-th black scan line SBLj of FIG. 4A. For example, the j-th black scan signal SBj (see FIG. 4A) may be applied to the first gate wire SBL. The first gate wire SBL may constitute the seventh transistor T7 of FIG. 4A, together with the first semiconductor pattern layer ACT1.

The second gate wire VIL may extend in the first direction DR1. The second gate wire VIL corresponds to the first initializing voltage line VIL (see FIG. 4A). The first initializing voltage Vint may be applied to the second gate wire VIL.

The third gate wire SWL corresponds to the j-th write scan line SWLj of FIG. 4A. For example, the j-th write scan signal SWj (see FIG. 4A) may be applied to the third gate wire SWL. The third gate wire SWL may constitute the second transistor T2 of FIG. 4A, together with the first semiconductor pattern layer ACT1.

The first gate electrode GE1 may be arranged in the shape of an island. The first gate electrode GE1 may constitute the first transistor T1 of FIG. 4A, together with the first semiconductor pattern layer ACT1. The first gate electrode GE1 may correspond to the third electrode G1 of the first transistor T1 illustrated in FIG. 6.

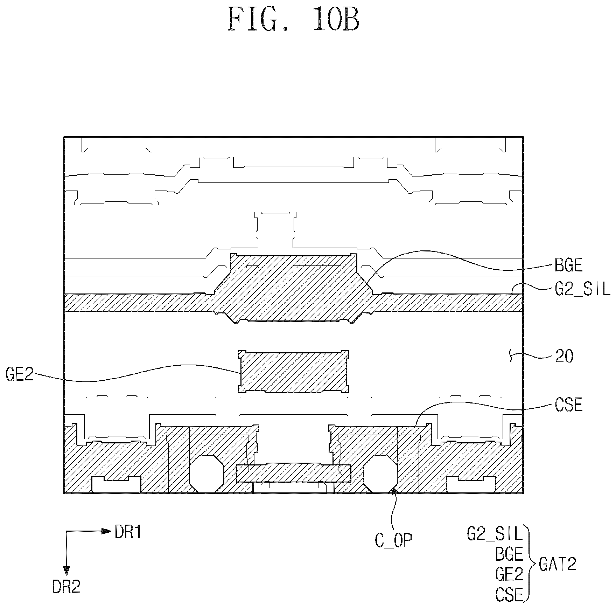

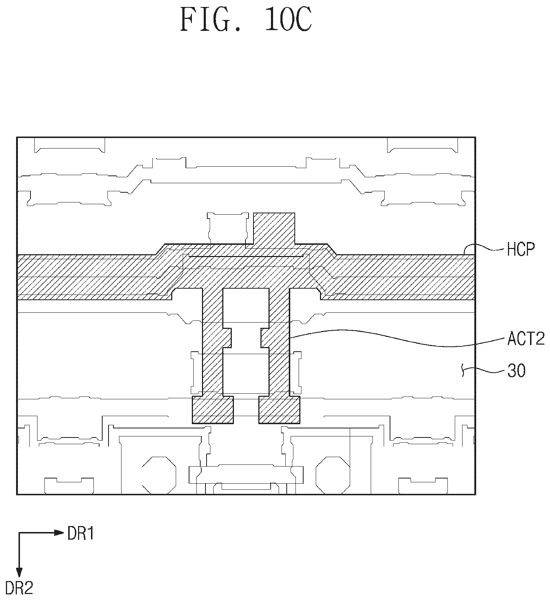

Referring to FIGS. 10B and 10C, the second insulating layer 20 may be located on the first insulating layer 10 while covering the first gate pattern layer GAT1. The second gate pattern layer GAT2 may be located on the second insulating layer 20. The second gate pattern layer GAT2 may include metal, an alloy, a conductive metal oxide, or a transparent conductive material.

The second gate pattern layer GAT2 may include a fourth gate wire G2_SIL, the capacitor electrode CSE, the bottom gate electrode BGE, and the second gate electrode GE2.

The fourth gate wire G2_SIL may extend in the first direction DR1. The fourth gate wire G2_SIL corresponds to the j-th initializing scan line SILj of FIG. 4A. For example, the j-th initializing scan signal SIj (see FIG. 4A) may be applied to the fourth gate wire G2_SIL. The bottom gate electrode BGE extends from the fourth gate wire G2_SIL. The bottom gate electrode BGE may correspond to the lower electrode BE illustrated in FIG. 6.

The capacitor electrode CSE may overlap with the first gate electrode GE1, and may be arranged in the shape of an island. The capacitor electrode CSE may constitute the capacitor Cst (see FIG. 4A) together with the first gate electrode GE1. The capacitor electrode CSE may correspond to the upper electrode UE illustrated in FIG. 6. According to some embodiments of the present disclosure, the plurality of capacitor electrodes CSE may be connected to each other in the first direction DR1. The capacitor electrode CSE may have an opening C_OP formed through the capacitor electrode CSE. The first gate electrode GE1 may be partially exposed through the opening C_OP.

The second gate electrode GE2 may correspond to the lower electrode additionally to face the second semiconductor pattern of the third transistor T3 of FIG. 4A.

Referring to FIGS. 10B and 10C, the third insulating layer 30 may be located on the second insulating layer 20 while covering the second gate pattern layer GAT2. Second semiconductor pattern layers may be located on the third insulating layer 30. The second semiconductor pattern layers may include a plurality of oxide semiconductor patterns ACT2 and the connecting pattern HCP. The second semiconductor pattern layers ACT2 and HCP may be located in a layer different from a layer for the first semiconductor pattern layer ACT1, and may not overlap with the first semiconductor pattern layer ACT1.

An oxide semiconductor patterns ACT2 may include a second semiconductor pattern of some transistors T3 and T4 included in the pixel driving circuit P_PD. According to some embodiments of the present disclosure, the oxide semiconductor patterns ACT2 may have the shape extending in the second direction DR2. The oxide semiconductor patterns ACT2 may be connected to each other through the connecting pattern HCP. The connecting pattern HCP may extend in the first direction DR1.

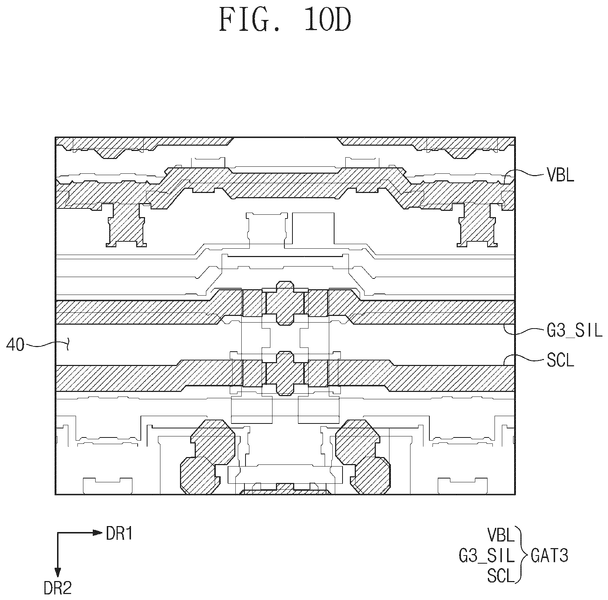

Referring to FIGS. 10C and 10D, the fourth insulating layer 40 may be located on the third insulating layer 30 while covering the second semiconductor pattern layers ACT2 and HCP. The third gate pattern layer GAT3 may be located on the fourth insulating layer 40. The third gate pattern layer GAT3 may include metal, an alloy, a conductive metal oxide, or a transparent conductive material.

The third gate pattern layer GAT3 may include a fifth gate wire SCL, a sixth gate wire G3_SIL, and a seventh gate wire VBL.

Each of the fifth to seventh gate wires SCL, G3_SIL, and VBL may extend in the first direction DR1. The fifth gate wire SCL corresponds to the j-th compensating scan line SCLj of FIG. 4A. Accordingly, the j-th compensating scan signal SCj may be applied to the fifth gate wire SCL. The fifth gate wire SCL may overlap with the oxide semiconductor pattern ACT2. The fifth gate wire SCL may constitute the third transistor T3 of FIG. 4A, together with the oxide semiconductor pattern ACT2.

The sixth gate wire G3_SIL may be electrically connected to the fourth gate wire G2_SIL, and may form the j-th initializing scan line SILj of FIG. 4A. According to some embodiments of the present disclosure, a portion of the sixth gate wire G3_SIL may correspond to the third electrode G4 of the fourth transistor T4 illustrated in FIG. 6. A portion of the sixth gate wire G3_SIL may overlap with the bottom gate electrode BGE illustrated in FIG. 10B.

A seventh gate wire VBL corresponds to the bias voltage line VBL illustrated in FIG. 4A. The bias voltage Vbias may be applied to the seventh gate wires VBL. The seventh gate wire VBL may constitute the eighth transistor T8 illustrated in FIG. 4A, together with the first semiconductor pattern layer ACT1.

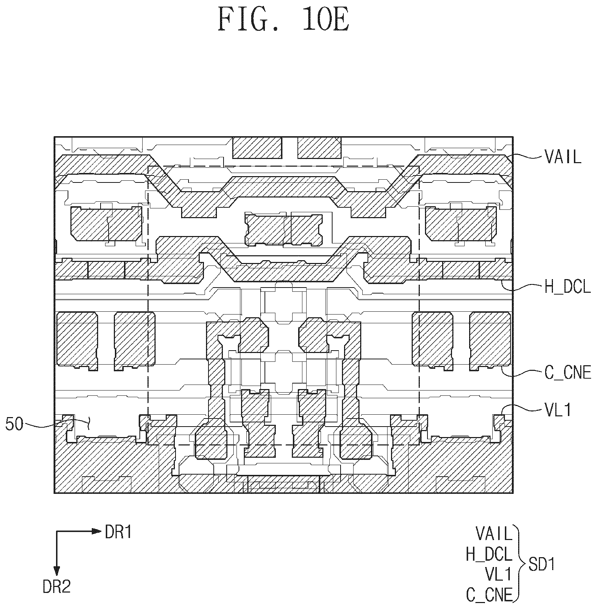

Referring to FIGS. 10D and 10E, the fifth insulating layer 50 may be located on the fourth insulating layer 40 while covering the third gate pattern layer GAT3. The first data pattern layer SD1 may be located on the fifth insulating layer 50. The first data pattern layer SD1 may include, for example, metal, an alloy, a conductive metal oxide, or a transparent conductive material.

The first data pattern layer SD1 may include a horizontal connecting line H_DCL, a first driving voltage line VL1, a second initializing voltage line VAIL, and a plurality of connecting electrode patterns C_CNE. In the following description about the first data pattern layer SD1, some duplicate description about the first data pattern layer SD1, which is made with reference to FIG. 7F, may be omitted.

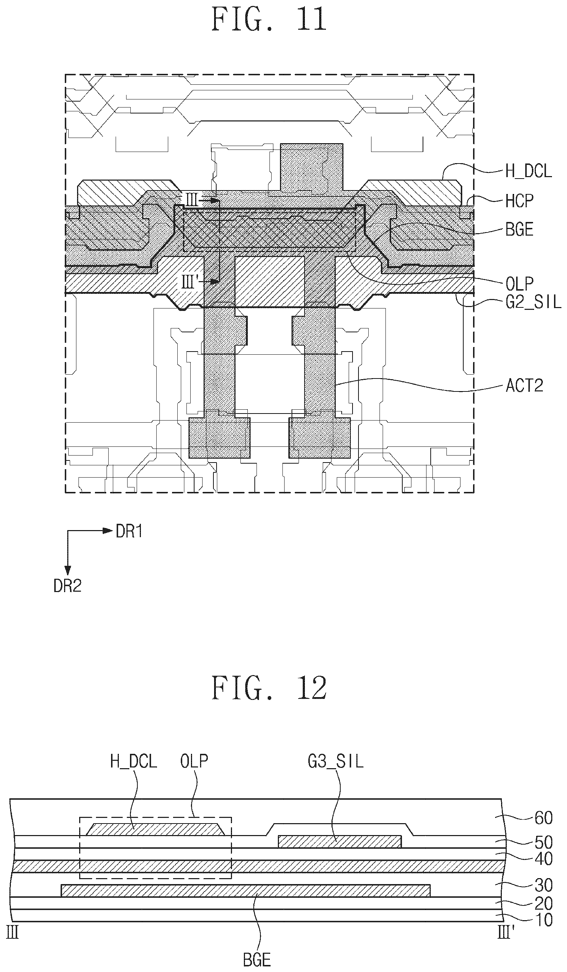

FIG. 11 is an enlarged plan view illustrating an enlarged portion of a display panel according to some embodiments of the present disclosure. FIG. 12 is a cross-sectional view taken along the line III-III' illustrated in FIG. 11.

Referring to FIGS. 8C, 11, and 12, the bottom gate electrode BGE may extend from the fourth gate wire G2_SIL, and may overlap with the oxide semiconductor pattern ACT2 when viewed in a plan view. According to some embodiments of the present disclosure, the connecting pattern HCP extends in the first direction DR1 to connect oxide semiconductor patterns ACT2 to each other. The connecting pattern HCP may extend from the oxide semiconductor patterns ACT2 and may have the shape integrated with the oxide semiconductor patterns ACT2. The connecting pattern HCP may partially overlap with the horizontal connecting line H_DCL to form the overlap part OLP, when viewed in a plan view. The bottom gate electrode BGE may extend to overlap with the connecting pattern HCP and the horizontal connecting line H_DCL. The bottom gate electrode BGE may extend to overlap with the overlap part OLP between the connecting pattern HCP and the horizontal connecting line H_DLC, when viewed in a plan view. The bottom gate electrode BGE may correspond to the lower electrode BE (that is, referred to as a "bottom gate") of the fourth transistor T4 illustrated in FIG. 6.

The bottom gate electrode BGE may receive the j-th initializing scan signal SIj (see FIG. 4B) through the fourth gate wire G2_SIL. The j-th initializing scan signal Slj has an active level (for example, the high level) for the first active period AP1 (see FIG. 4B).

A parasitic transistor P_TR may be formed in the overlap part OLP between the connecting pattern HCP and the horizontal connecting line H_DCL. As the parasitic transistor P_TR is turned on/off, the first initializing voltage Vint may not be applied to the fourth transistor T4 normally. However, when the bottom gate electrode BGE extends until the overlap part OLP, the parasitic transistor P_TR may be on-biased by the bottom gate electrode BGE for the first active period AP1. Accordingly, an amount of current flowing through the parasitic transistor P_TR is increased for the first active period AP1, so the first initializing voltage Vint is applied to the fourth transistor T4 normally for the first active period AP1.

Although FIGS. 11 and 12 illustrate the structure in which the bottom gate electrode BGE overlaps with the overlap part OLP, and the sixth gate wire G3_SIL is in a non-overlap with the overlap part OLP, embodiments according to the present disclosure are not limited thereto. Alternatively, the bottom gate electrode BGE may be in the non-overlapping state with the overlap part OLP, and the sixth gate wire G3_SIL may overlap with the overlap part OLP.

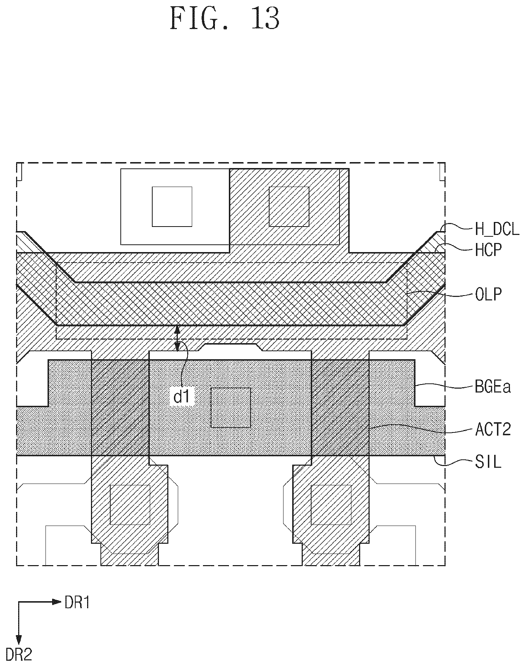

FIG. 13 is an enlarged plan view illustrating an enlarged portion of a display panel according to some embodiments of the present disclosure.

Referring to FIG. 13, the connecting pattern HCP may partially overlap with the horizontal connecting line H_DCL to form the overlap part OLP, when viewed in a plan view. The bottom gate electrode BGEa and the second gate electrode GE2 may be in the non-overlapping state with the overlap part OLP.

The horizontal connecting line H_DCL may overlap with the connecting pattern HCP, and may be in the non-overlap with the oxide semiconductor patterns ACT2. The horizontal connecting line H_DCL may be spaced apart from an edge of each of the oxide semiconductor patterns ACT2 by a first distance d1 in the second direction DR2. According to some embodiments of the present disclosure, the first distance 'd1' may have the size of at least 1.5 *µ*m.

When the horizontal connecting line H_DCL overlaps with the oxide semiconductor patterns ACT2, an amount of current flowing through the parasitic transistor P_TR (see FIG. 8C) may be reduced. Accordingly, the first initializing voltage Vint may not be applied to the fourth transistor T4 normally. In this case, the pixel PXij (see FIG. 4A) may not be initialized normally for the first active period AP1, so the brightness of the pixel PXij may be lowered.

However, when the horizontal connecting line H_DCL is sufficiently spaced apart from the edge of each of the oxide semiconductor patterns ACT2, as an amount of current flowing through the parasitic transistor P_TR is sufficiently ensured, the amount of current may be constantly maintained. Accordingly, the first initializing voltage Vint may be applied to the fourth transistor T4 normally for the first active period AP1. In other words, the initializing operation of the pixel PXij may be normally performed for the first active period AP1, thereby preventing or reducing instances of display stains being caused in a portion in which the horizontal connecting line H_DCL is located.

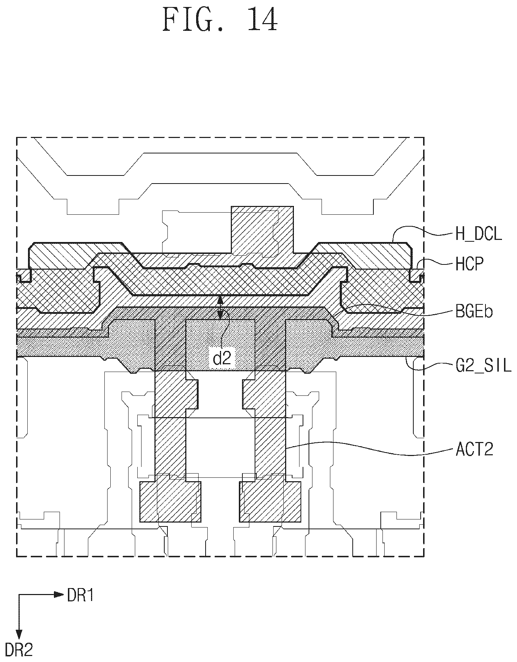

FIG. 14 is an enlarged plan view illustrating an enlarged portion of a display panel according to some embodiments of the present disclosure.

Referring to FIG. 14, a bottom gate electrode BGEb extending from a fourth gate wire G2_SIL may be in a non-overlapping state with the horizontal connecting line H_DCL, when viewed in a plan view. According to some embodiments of the present disclosure, although the bottom gate electrode BGEb partially overlaps with the connecting pattern HCP, when viewed in a plan view, embodiments according to the present disclosure are not limited thereto. For example, the bottom gate electrode BGEb may be in the non-overlapping state with the connecting pattern HCP, when viewed in a plan view.

The horizontal connecting line H_DCL may overlap with the connecting pattern HCP, when viewed in a plan view and may be in the non-overlap with the oxide semiconductor patterns ACT2. The horizontal connecting line H_DCL may be spaced apart from an edge of each of the oxide semiconductor patterns ACT2 by a second distance d2 in the second direction DR2. According to some embodiments of the present disclosure, the second distance 'd2' may have the size of at least 1.5 *µ*m.

As described above, when the horizontal connecting line H_DCL is sufficiently spaced apart from the edge of each of the oxide semiconductor patterns ACT2, as an amount of current flowing through the parasitic transistor P_TR is sufficiently ensured, the amount of current may be constantly maintained. Accordingly, the first initializing voltage Vint may be applied to the fourth transistor T4 normally for the first active period AP1. In other words, the initializing operation of the pixel PXij may be normally performed for the first active period AP1, thereby preventing or reducing instances of display stains being caused in a portion in which the horizontal connecting line H_DCL is located.

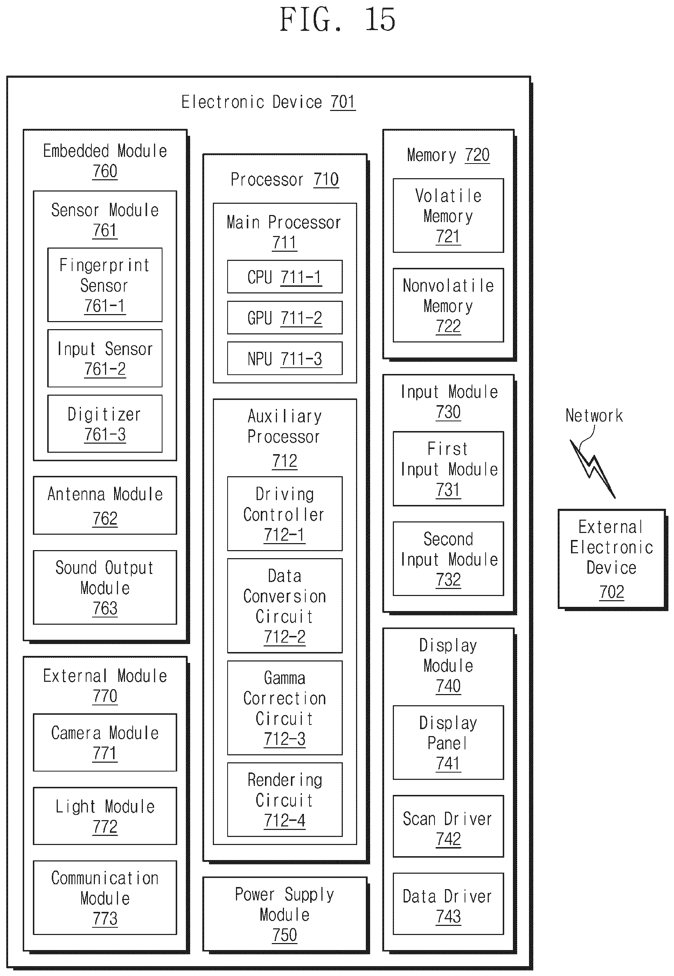

FIG. 15 is a block diagram of an electronic device, according to some embodiments of the present disclosure.

Referring to FIG. 15, an electronic device 701 outputs various pieces of information through a display module 740 within an operating system. When a processor 710 executes an application stored in a memory 720, a display module 740 provides application information to a user through a display panel 741.

The processor 710 obtains an external input through an input module 730 or a sensor module 761 and executes an application corresponding to the external input. For example, when the user selects a camera icon displayed on the display panel 741, the processor 710 obtains a user input through an input sensor 761-2 and activates a camera module 771. The processor 710 delivers image data corresponding to a captured image obtained through the camera module 771 to the display module 740. The display module 740 may display an image corresponding to the captured image through the display panel 741.

For another example, when personal information is authenticated on the display module 740, a fingerprint sensor 761-1 obtains entered fingerprint information as input data. The processor 710 compares input data obtained through the fingerprint sensor 761-1 with authentication data stored in the memory 720 and executes an application based on the comparison result. The display module 740 may display information, which is executed depending on the logic of the application, through the display panel 741.

For another example, when a music streaming icon displayed on the display module 740 is selected, the processor 710 obtains a user input through the input sensor 761-2 and activates the music streaming application stored in the memory 720. When a music play command is input by the music streaming application, the processor 710 provides sound information corresponding to the music play command to the user by activating a sound output module 763.

The operation of the electronic device 701 has been briefly described above. Hereinafter, a configuration of the electronic device 701 will be described in detail. Some of components of the electronic device 701, which will be described below, may be integrated and provided as one configuration, or the one configuration may be provided to be separated into two or more configurations.

Referring to FIG. 15, the electronic device 701 may communicate with an external electronic device 702 through a network (e.g., a short-range wireless communication network or a long-range wireless communication network). According to some embodiments, the electronic device 701 may include the processor 710, the memory 720, the input module 730, the display module 740, a power supply module 750, an embedded module 760, and an external module 770. According to some embodiments, in the electronic device 701, at least one of the above-described components may be omitted, or one or more other components may be added. According to some embodiments, some (e.g., the sensor module 761, an antenna module 762, or the sound output module 763) of the components described above may be integrated into another component (e.g., the display module 740).

The processor 710 may execute software to control at least another component (e.g., hardware or software component) of the electronic device 701 connected to the processor 710, and may process and calculate various types of data. According to some embodiments, as at least part of data processing or calculation, the processor 710 may store instructions or data received from other components (e.g., the input module 730, the sensor module 761 or a communication module 773) into a volatile memory 721, may process instructions or data stored in the volatile memory 721. The result data may be stored in a nonvolatile memory 722.

The processor 710 may include a main processor 711 and an auxiliary processor 712. The main processor 711 may include one or more of a central processing unit (CPU) 711-1 or an application processor (AP). The main processor 711 may further include one or more of a graphic processing unit (GPU) 711-2, a communication processor (CP), and an image signal processor (ISP). The main processor 711 may further include a neural processing unit (NPU) 711-3. The NPU 711-3 may be a processor that is specialized in processing an artificial intelligence model. The artificial intelligence model may be generated through machine learning. The artificial intelligence model may include a plurality of artificial neural network layers. The artificial neural network may be one of a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more of the networks, but may not be limited to the above-described example. In addition to a hardware structure, additionally or alternatively, the artificial intelligence model may include a software structure. At least two of the processing units and the processors that are described above may be implemented as one integrated component (e.g., a single chip) or may be implemented as independent components (e.g., a plurality of chips).

The auxiliary processor 712 may include a driving controller 712-1. The driving controller 712-1 may include an interface converting circuit and a timing control circuit. The driving controller 712-1 receives an image signal from the main processor 711, converts the data format of the image signal so as to be suitable for the interface specifications with the display module 740, and outputs image data. The driving controller 712-1 may output various control signals required to drive the display module 740. The configuration of the driving controller 712-1 is the same (or substantially similar) to the driving controller 100 shown in FIG. 3, and thus some detailed descriptions may be omitted to avoid redundancy.

The auxiliary processor 712 may further include a data converting circuit 712-2, a gamma correcting circuit 712-3, and a rendering circuit 712-4. The data converting circuit 712-2 may receive the image data from the driving controller 712-1 and may compensates for the image data such that an image is displayed at a desired luminance according to characteristics of the electronic device 701 or setting of the user or may convert the image data to reduce power consumption or compensate for afterimages. The gamma correcting circuit 712-3 may convert the image data, a gamma reference voltage, or the like such that the image displayed on the electronic device 701 has desired gamma characteristics. The rendering circuit 712-4 may receive the image data from the driving controller 712-1 and may render the image data in consideration of a pixel arrangement of the display panel 741 applied to the electronic device 701. At least one of the data converting circuit 712-2, the gamma correcting circuit 712-3, or the rendering circuit 712-4 may be integrated into another component (e.g., the main processor 711 or the driving controller 712-1). At least one of the data converting circuit 712-2, the gamma correcting circuit 712-3, or the rendering circuit 712-4 may be integrated into a data driver 743.

The memory 720 may store various pieces of data, which are used by at least one component (e.g., the processor 710 or the sensor module 761) of the electronic device 701 and input data or output data for commands related thereto. The memory 720 may include at least one or more of the volatile memory 721 and the nonvolatile memory 722.

The input module 730 may receive, from the outside (e.g., the user or an external electronic device 702) of the electronic device 701, commands or data to be used in components (e.g., the processor 710, the sensor module 761, or the sound output module 763) of the electronic device 701.

The input module 730 may include a first input module 731, through which the commands or data are input from the user, and a second input module 732 through which the commands or data are input from the external electronic device 702. The first input module 731 may include a microphone, a mouse, a keyboard, a key (e.g., a button), or a pen (e.g., a passive pen or an active pen). The second input module 732 may support a designated protocol capable of being connected to the external electronic device 702 by wire or wirelessly. According to some embodiments, the second input module 732 may include a high definition multimedia interface (HDMI), a universal serial bus (USB) interface, a secure digital (SD) card interface, or an audio interface. The second input module 732 may include a connector that may be physically connected to the external electronic device 702, for example, an HDMI connector, a USB connector, an SD card connector, or an audio connector (e.g., a headphone connector).

The display module 740 provides visual information to the user. The display module 740 may include the display panel 741, a scan driver 742, and the data driver 743. The display module 740 may further include a window, a chassis, a bracket, or the like for protecting the display panel 741. The display module 740 may further include a light emitting driver, a voltage generator, and the like. The voltage generator may output various voltages (e.g., the first and second driving voltages ELVDD and ELVSS (see FIG. 3)) required to drive the display panel 741. The configuration of the display panel 741, the scan driver 742, the data driver 743, and the voltage generator is the same (or substantially similar) to the configuration of the display panel DP, the scan driver 300, the light emitting driver 350, , the data driver 200, and the voltage generator 400 shown in FIG. 3, and thus some detailed descriptions may be omitted to avoid redundancy.

The power supply module 750 supplies power to the components of the electronic device 701. The power supply module 750 may include a battery that charges a power voltage. The battery may include a non-rechargeable primary cell, a rechargeable secondary cell, a fuel cell, or the like. The power supply module 750 may include a power management integrated circuit (PMIC). The PMIC supplies optimized power to the above-described modules and modules which will be described below. The power supply module 750 may include a wireless power transmission/reception member electrically connected to the battery. The wireless power transmission/reception member may include a plurality of coil-shaped antenna radiators.

The electronic device 701 may further include the embedded module 760 and the external module 770. The embedded module 760 may include the sensor module 761, the antenna module 762, and the sound output module 763. The external module 770 may include the camera module 771, a light module 772, and the communication module 773.

The sensor module 761 may detect an input from the user's body or an input from a pen among the first input module 731, and may generate an electrical signal or data value corresponding to the input. The sensor module 761 may include at least one of the fingerprint sensor 761-1, the input sensor 761-2, or a digitizer 761-3.

The fingerprint sensor 761-1 may generate a data value corresponding to a fingerprint of the user. The fingerprint sensor 761-1 may include one of an optical-type fingerprint sensor, or a capacitance-type fingerprint sensor.

The input sensor 761-2 may generate a data value corresponding to coordinate information of an input by a body of the user or an input by a pen. The input sensor 761-2 generates the change in capacitance due to the input as the data value. The input sensor 761-2 may sense an input by a passive pen or may transmit or receive data to or from an active pen.

The input sensor 761-2 may also measure a biometric signal such as blood pressure, moisture, or body fat. For example, when the user touches a part of the body to a sensor layer or sensing panel and does not move during a specific period, the input sensor 761-2 may detect the biometric signal and may output information desired by the user to the display module 740 based on changes in electric fields caused by the part of the body.

The digitizer 761-3 may generate the data value corresponding to coordinate information of an input by the pen. The digitizer 761-3 generates an electromagnetic change amount due to the input as the data value. The digitizer 761-3 may sense input by the passive pen or transmit or receive data to or from the active pen.

At least one of the fingerprint sensor 761-1, the input sensor 761-2, or the digitizer 761-3 may be implemented as a sensor layer formed on the display panel 741 through a subsequent process. The fingerprint sensor 761-1, the input sensor 761-2, and the digitizer 761-3 may be placed on the upper side of the display panel 741, and one (e.g., the digitizer 761-3) of the fingerprint sensor 761-1, the input sensor 761-2, and the digitizer 761-3 may be placed on the lower side of the display panel 741.

At least two or more of the fingerprint sensors 761-1, the input sensor 761-2, and the digitizer 761-3 may be formed to be integrated into one sensing panel through the same process. When being integrated into one sensing panel, the sensing panel may be placed between the display panel 741 and a window placed on the upper side of the display panel 741. According to some embodiments, the sensing panel may be placed on a window, and the location of the sensing panel is not particularly limited thereto.

At least one of the fingerprint sensor 761-1, the input sensor 761-2, or the digitizer 761-3 may be built into the display panel 741. That is, at least one of the fingerprint sensor 761-1, the input sensor 761-2, or the digitizer 761-3 may be simultaneously (or concurrently) formed through a process of forming elements (e.g., a light emitting element, a transistor, or the like) included in the display panel 741.

Besides, the sensor module 761 may generate an electrical signal or a data value corresponding to the internal state or external state of the electronic device 701. For example, the sensor module 761 may further include a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, or an illumination sensor.

The antenna module 762 may include one or more antennas to transmit or receive the signal or power to or from an external source. According to some embodiments, the communication module 773 may transmit or receive the signal to or from the external electronic device 702 through the antenna suitable for a communication method. An antenna pattern of the antenna module 762 may be integrated into the input sensor 761-2 or one component (e.g., the display panel 741) of the display module 740.

The sound output module 763 may be a device for outputting an audio signal to the outside of the electronic device 701 and, for example, may include a speaker used for general purposes, such as multimedia playback or recording playback, and a receiver used only for receiving a call. According to some embodiments, the receiver may be implemented separately from the speaker or may be integrated with the speaker. A sound output pattern of the sound output module 763 may be integrated into the display module 740.

The camera module 771 may shoot a still image or a video image. According to some embodiments, the camera module 771 may include one or more lenses, an image sensor, or an image signal processor. The camera module 771 may further include an infrared camera capable of measuring the presence or absence of the user, a position of the user, a gaze of the user, or the like.

The light module 772 may provide light. The light module 772 may include a light emitting diode or a xenon lamp. The light module 772 may operate in conjunction with the camera module 771 or may operate independently from the camera module 771.

The communication module 773 may support establishing a wired or wireless communication channel between the electronic device 701 and the external electronic device 702 and performing communication through the established communication channel. The communication module 773 may include one or all of wireless communication modules such as a cellular communication module, a short-range wireless communication module, or a global navigation satellite system (GNSS) communication module, or wired communication modules such as a local area network (LAN) communication module or a power line communication module. The communication module 773 may communicate with the external electronic device 702 through a short-range communication network such as Bluetooth, WiFi direct, or infrared data association (IrDA) or a long-range communication network such as a cellular network, Internet, or a computer network (e.g., the LAN or a wide area network (WAN)). The above-mentioned various communication modules 773 may be implemented into one chip or may be respectively implemented into separate chips.

The input module 730, the sensor module 761, the camera module 771, and the like may be utilized to control an operation of the display module 740 in conjunction with the processor 710.

The processor 710 outputs commands or data to the display module 740, the sound output module 763, the camera module 771, or the light module 772 based on input data received from the input module 730. For example, the processor 710 may generate image data in response to input data applied through a mouse, an active pen, or the like to output the generated image data to the display module 740 or may generate command data in response to the input data to output the generated command data to the camera module 771 or the light module 772. When no input data is received from the input module 730 during a specific period, the processor 710 may switch an operation mode of the electronic device 701 to a low-power mode or a sleep mode to reduce power consumed in the electronic device 701.

The processor 710 outputs commands or data to the display module 740, the sound output module 763, the camera module 771, or the light module 772 based on sensing data received from the sensor module 761. For example, the processor 710 may compare authentication data authorized by the fingerprint sensor 761-1 with the authentication data stored in the memory 720, and then may execute an application depending on the comparison result. The processor 710 may execute commands or may output corresponding image data to the display module 740 based on sensing data sensed by the input sensor 761-2 or the digitizer 761-3. When the sensor module 761 includes a temperature sensor, the processor 710 receives temperature data regarding the measured temperature from the sensor module 761 and may further perform luminance correction on image data based on the temperature data.

The processor 710 may receive measurement data regarding the presence or absence of the user, the user's location, and the user's gaze from the camera module 771. The processor 710 may further perform luminance correction on the image data based on the measurement data. For example, the processor 710 that determines the presence or absence of the user through an input from the camera module 771 may output image data, of which the luminance is corrected, to the display module 740 through the data converting circuit 712-2 or the gamma correcting circuit 712-3.

Some of the components may be connected to each other through communication methods between peripheral devices, for example, a bus, a general purpose input/output (GPIO), a serial peripheral interface (SPI), a mobile industry processor interface (MIPI), or an ultra-path interconnect (UPI) link and may exchange a signal (e.g., commands or data) between each other. The processor 710 may communicate with the display module 740 through a mutually promised interface, and for example, may use any one of the above-described communication methods, and embodiments according to the present disclosure are not limited to the above-described communication methods.

The electronic device 701 according to various embodiments disclosed in the specification may be implemented with various types of devices. The electronic device 701 may include, for example, at least one of a portable communication device (e.g., a smart phone), a computer device, a portable multimedia device, a portable medical device, a camera, a wearable device, or a home appliance. The electronic device 701 according to some embodiments of this specification may not be limited to the above-described devices.

As discussed, embodiments can provide a display device comprising: a base layer including a display region and a non-display region defined in the base layer; a circuit layer on the base layer; and an element layer on the circuit layer, and including a light emitting element, wherein the circuit layer includes: a pixel circuit connected to the light emitting element; a data line connected to the pixel circuit; a vertical connecting line spaced apart from the data line in a first direction, and extending in a second direction; and a horizontal connecting line configured to connect the vertical connecting line to the data line in the display region, and extending in the first direction, wherein the pixel circuit includes a transistor including an oxide semiconductor pattern, wherein the horizontal connecting line includes an overlap part overlapping with a connecting pattern extending from the oxide semiconductor pattern, and wherein the transistor includes a gate overlapping with the overlap part.

The data line may extend in the second direction.

In some embodiments, the pixel circuit includes a plurality of pixel circuits in the circuit layer, and wherein a plurality of oxide semiconductor patterns on the plurality of pixel circuits, respectively, are connected to each other, in the first direction, through the connecting pattern. Hence, the oxide semiconductor patterns may be connected to each other through the connecting pattern.

In some embodiments, pixel circuits are connected to the light emitting element.

In some embodiments, the horizontal connecting line overlaps with the connecting pattern to connect oxide semiconductor patterns of the pixel circuits to each other, and is in a non-overlapping state with the oxide semiconductor patterns. The oxide semiconductor patterns may extend in the second direction, and the connecting pattern may extend in the first direction.

The horizontal connecting line may be spaced apart from an edge of each of the oxide semiconductor patterns by a distance of at least 1.5 *µ*m, in the second direction.

The display panel may include a display region and a non-display region. A plurality of pixels may be located in the display region. A driving chip may be mounted in the non-display region.

Data lines may be connected to the plurality of pixels in the display region, and connected to the driving chip in the non-display region.

The data lines may be grouped into a first group and a second group. The first group includes a plurality of first data lines, and the second group includes a plurality of second data lines. The plurality of first data lines may be arranged in the first direction, and the plurality of second data lines may be arranged in the first direction. The plurality of first data lines may be spaced apart from the plurality of second data lines in the first direction.

The plurality of first data lines may be for a first group of pixels of the plurality of pixels, and the plurality of second data lines may be for a second group of pixels of the plurality of pixels. The first group of pixels and the first data lines may be located in a first region, and the second group of pixels and the second data lines may be located in a second region.

The first region may at least partially overlap the region of the driving chip when considered in the second direction. The second region may be adjacent to the first region in the first direction.

The display device may be considered to include data connecting lines to connect the second data lines to the driving chip. The data connecting lines include a plurality of vertical connecting lines extending in the second direction along the first data lines and a plurality of horizontal connecting lines extending in the first direction.

Some of the vertical connecting lines and the horizontal connecting lines may be located in the display region. In other words, some of data lines to connect the second data lines to the driving chip mya be located in the display region. Accordingly, an area of a region occupied by the data connecting lines may be reduced in the non-display region, so the area of the dead space of the display panel may be reduced.

The gate of the transistor may include: a top gate at an upper portion of the oxide semiconductor pattern; and a bottom gate at a lower portion of the oxide semiconductor pattern.

The bottom gate electrode may extend from a gate wire, and may overlap with the oxide semiconductor pattern when viewed in a plan view. The bottom gate may overlap with the overlap part.

The bottom gate electrode may extend to overlap with the connecting pattern and the horizontal connecting line. The bottom gate electrode may extend to overlap with the connecting pattern and the overlap part of the horizontal connecting line when viewed in a plan view.

The bottom gate electrode may receive a scan signal, e.g. an initializing scan signal.

A parasitic transistor may be formed in the overlap part between the connecting pattern and the horizontal connecting line.

In some embodiments, the connecting pattern is in a non-overlapping state with the top gate and the bottom gate.

A first transistor may be connected between a first driving voltage line for receiving the first driving voltage and the light emitting element. The first transistor may include a first electrode connected to the first driving voltage line (e.g. through a fifth transistor), a second electrode connected to an anode electrode of the light emitting element (e.g. through a sixth transistor T6), and a third electrode (for example, a gate electrode) connected to the first terminal (for example, a first node N1) of a capacitor. The first transistor may receive the data signal through a data line depending on a switching operation of a second transistor and then may supply a driving current to the light emitting element.

A second transistor may be connected between the data line and the first electrode of the first transistor. The second transistor may include a first electrode connected to the data line, a second electrode connected to the first electrode of the first transistor 1, and a third electrode (for example, a gate electrode) connected to a write scan line. The second transistor may be turned on in response to the write scan signal transmitted through the write scan line to transmit a data signal transmitted from the data line to the first electrode of the first transistor.

A third transistor may be connected between the second electrode of the first transistor and a first node. The third transistor may include a first electrode connected to the third electrode of the first transistor, a second electrode connected to the second electrode of the first transistor T1and a third electrode (for example, a gate electrode) connected to a compensating scan line. The third transistor may be turned on in response to the compensating scan signal, which is received through the compensating scan line, to connect the third electrode and the second electrode of the first transistor, such that the first transistor may be diode-connected.

A fourth transistor may be connected between a first initializing voltage line applied with the first initializing voltage and the first node. The fourth transistor includes a first electrode connected to the first initializing voltage line for transmitting the first initializing voltage Vit, a second electrode connected to the first node N, and a third electrode (for example, a gate electrode) connected to an initializing scan line. The fourth transistor may be turned on in response to the initializing scan signal received through the initializing scan line. The fourth transistor when turned on may transmit the first initializing voltage to the first node to initialize a potential (that is, a potential of the first node) of the third electrode of the first transistor. The transistor that includes a gate overlapping with the overlap part may be the fourth transistor.

The oxide semiconductor pattern may include a semiconductor pattern of the third and fourth transistors.

Embodiments can provide a display device comprising: a base layer including a display region and a non-display region defined in the base layer; a circuit layer on the base layer; and an element layer on the circuit layer, and including a light emitting element, wherein the circuit layer includes: pixel circuits connected to the light emitting element; a data line connected to the pixel circuits; a vertical connecting line spaced apart from the data line in a first direction, and extending in a second direction; and a horizontal connecting line configured to connect the vertical connecting line to the data line in the display region, wherein each of the pixel circuits includes a transistor including an oxide semiconductor pattern, and wherein the horizontal connecting line overlaps with a connecting pattern to connect oxide semiconductor patterns of the pixel circuits to each other, and is in a non-overlapping state with the oxide semiconductor patterns.

Embodiments can provide an electronic device comprising: a display panel including a pixel; a panel driver configured to drive the display panel; a driving controller configured to control driving of the panel driver; and a main processor configured to provide an image signal to the driving controller, wherein the display panel is according to any of the above mentioned embodiments.

According to some embodiments of the present disclosure, as the bottom gate electrode of the fourth transistor may extend until the overlap part between the horizontal connecting line and the connecting pattern, the parasitic transistor formed between the horizontal connecting line and the connecting pattern may be on-biased by the bottom gate electrode. Accordingly, the amount of current flowing through the parasitic transistor may be relatively increased, such that the first initializing voltage is applied to the fourth transistor normally. Accordingly, the display stains may be prevented or reduced in the part in which the horizontal connecting line is located, thereby providing relatively improved overall display quality of the display device.

While the present disclosure has been described with reference to embodiments thereof, it will be apparent to those of ordinary skill in the art that various changes and modifications may be made thereto without departing from the scope of the present disclosure as set forth in the following claims, and their equivalents.

## Claims

1. A display device comprising:
a base layer including a display region and a non-display region defined in the base layer;
a circuit layer on the base layer; and
an element layer on the circuit layer, and including a light emitting element,
wherein the circuit layer includes:
a pixel circuit connected to the light emitting element;
a data line connected to the pixel circuit;
a vertical connecting line spaced apart from the data line in a first direction, and extending in a second direction; and
a horizontal connecting line configured to connect the vertical connecting line to the data line in the display region, and extending in the first direction,
wherein the pixel circuit includes a transistor including an oxide semiconductor pattern,
wherein the horizontal connecting line includes an overlap part overlapping with a connecting pattern extending from the oxide semiconductor pattern, and
wherein the transistor includes a gate overlapping with the overlap part.

2. The display device of claim 1, wherein the gate of the transistor includes:
a top gate at an upper portion of the oxide semiconductor pattern; and
a bottom gate at a lower portion of the oxide semiconductor pattern.

3. The display device of claim 2, wherein the bottom gate overlaps with the overlap part.

4. The display device of claim 3, wherein the circuit layer further includes:
an initializing scan line extending in the first direction, and
wherein the bottom gate extends from the initializing scan line.

5. The display device of claim 4, wherein the circuit layer further includes:
a first gate pattern layer including the initializing scan line on a first insulating layer;
a second insulating layer covering the first gate pattern layer;
a second gate pattern layer on the second insulating layer; and
a third insulating layer covering the second gate pattern layer, and
wherein the oxide semiconductor pattern and the connecting pattern are on the third insulating layer.

6. The display device of claim 4 or 5, wherein the circuit layer further includes:
a first gate pattern layer on a first insulating layer;
a second insulating layer covering the first gate pattern layer;
a second gate pattern layer on the second insulating layer, and including the initializing scan line; and
a third insulating layer covering the second gate pattern layer, and
wherein the oxide semiconductor pattern and the connecting pattern are on the third insulating layer;
optionally wherein the circuit layer further includes:
a fourth insulating layer covering the oxide semiconductor pattern and the connecting pattern;
a third gate pattern layer on the fourth insulating layer;
a fifth insulating layer covering the third gate pattern layer; and
a first data pattern layer on the fifth insulating layer, and including the horizontal connecting line.

7. The display device of any one of claims 2 to 6, wherein the bottom gate is electrically connected to the top gate.

8. The display device of any one of claims 1 to 7, wherein the pixel circuit includes a plurality of pixel circuits in the circuit layer, and
wherein a plurality of oxide semiconductor patterns on the plurality of pixel circuits, respectively, are connected to each other, in the first direction, through the connecting pattern.

9. The display device of claim 8, wherein the connecting pattern and the plurality of oxide semiconductor patterns are provided in an integral form.

10. The display device of claim 8 or 9, wherein the oxide semiconductor patterns extend in the second direction,
wherein the connecting pattern extends in the first direction, and
wherein the horizontal connecting line is in a non-overlapping state with the oxide semiconductor patterns;
**optionally** wherein the horizontal connecting line is spaced apart from an edge of each of the oxide semiconductor patterns by a distance of at least 1.5 *µ*m, in the second direction.

11. A display device comprising:
a base layer including a display region and a non-display region defined in the base layer;
a circuit layer on the base layer; and
an element layer on the circuit layer, and including a light emitting element,
wherein the circuit layer includes:
pixel circuits connected to the light emitting element;
a data line connected to the pixel circuits;
a vertical connecting line spaced apart from the data line in a first direction, and extending in a second direction; and
a horizontal connecting line configured to connect the vertical connecting line to the data line in the display region,
wherein each of the pixel circuits includes a transistor including an oxide semiconductor pattern, and
wherein the horizontal connecting line overlaps with a connecting pattern to connect oxide semiconductor patterns of the pixel circuits to each other, and is in a non-overlapping state with the oxide semiconductor patterns.

12. The display device of claim 11, wherein the oxide semiconductor patterns extend in the second direction, and wherein the connecting pattern extends in the first direction, optionally wherein the horizontal connecting line is spaced apart from an edge of each of the oxide semiconductor patterns by a distance of at least 1.5 *µ*m, in the second direction; and/or
wherein the connecting pattern and the plurality of oxide semiconductor patterns are provided in an integral form.

13. The display device of claim 11 or 12, wherein the circuit layer further includes:
a first gate pattern layer on a first insulating layer;
a second insulating layer covering the first gate pattern layer; and
a second gate pattern layer on the second insulating layer;
a third insulating layer covering the gate pattern layer, and
wherein the oxide semiconductor patterns and the connecting pattern are on the third insulating layer;
optionally wherein the circuit layer further includes:
a fourth insulating layer covering the oxide semiconductor patterns and the connecting pattern;
a third gate pattern layer on the fourth insulating layer;
a fifth insulating layer covering the third gate pattern layer; and
a first data pattern layer on the fifth insulating layer, and including the horizontal connecting line.

14. The display device of any one of claims 11 to 13, wherein a gate of the transistor includes:
a top gate at an upper portion of the oxide semiconductor pattern; and
a bottom gate at a lower portion of the oxide semiconductor pattern,
wherein the connecting pattern is in a non-overlapping state with the top gate and the bottom gate.

15. An electronic device comprising:
a display panel including a pixel;
a panel driver configured to drive the display panel;
a driving controller configured to control a driving of the panel driver; and
a main processor configured to provide an image signal to the driving controller,
wherein the display panel is according to any one of claims 1 to 14.
